# EUROPEAN PATENT SPECIFICATION

(11) **EP 4 478 401 B1**
(45) Date of publication and mention of the grant of the patent: **30.09.2026**
(21) Application number: 23794984.7
(22) Date of filing: 07.04.2023
(51) Int. Cl.: H10W 20/00, H10W 20/41, H10W 72/00, H10W 72/90, H10W 80/00, H10W 90/00

(54) **INTEGRATED CIRCUIT, PREPARATION METHOD THEREFOR, THREE-DIMENSIONAL INTEGRATED CIRCUIT AND ELECTRONIC APPARATUS**
INTEGRIERTE SCHALTUNG, HERSTELLUNGSVERFAHREN DAFÜR, DREIDIMENSIONALE INTEGRIERTE SCHALTUNG UND ELEKTRONISCHE VORRICHTUNG
CIRCUIT INTÉGRÉ, SON PROCÉDÉ DE PRÉPARATION, CIRCUIT INTÉGRÉ TRIDIMENSIONNEL ET APPAREIL ÉLECTRONIQUE

(30) Priority: 29.04.2022 CN 202210468669
(43) Date of publication of application: 18.12.2024
(73) Proprietor: Huawei Technologies Co., Ltd., Shenzhen, Guangdong 518129 (CN)
(72) Inventor: HE, Ran, Shenzhen, Guangdong 518129 (CN)
(74) Representative: Pfenning, Meinig & Partner mbB
(86) International application number: PCT/CN2023/086865
(87) International publication number: WO 2023/207551

(56) References cited:
- CN-A- 102 544 354
- CN-A- 104 538 346
- CN-A- 105 374 774
- CN-A- 112 802 849
- CN-A- 113 675 098
- CN-A- 113 675 104
- US-A1- 2008 079 154
- US-A1- 2014 217 593
- US-A1- 2016 013 135
- US-A1- 2016 329 242
- US-A1- 2016 336 272
- US-A1- 2016 381 795
- US-A1- 2017 117 253
- US-A1- 2017 186 715
- US-A1- 2021 257 293
- US-A1- 2021 287 994
- US-A1- 2022 068 826

## Description

### TECHNICAL FIELD

This application relates to the field of semiconductor technologies, and in particular, to an integrated circuit and a preparation method thereof, a three-dimensional integrated circuit, and an electronic device.

### BACKGROUND

US 2021/257293 A1 describes an interconnect structure of a multi-layer interconnect feature of an integrated circuit device.
US 2016/329242 A1 describes a method of forming a wiring structure, in which an insulating interlayer is formed on a substrate. The insulating interlayer includes an opening and has pores distributed therein and exposed at a surface thereof. The insulating interlayer is exposed to a silane compound to form a pore sealing layer on the surface of the insulating interlayer and a sidewall of the opening. A conductive pattern filling the opening is formed on the pore sealing layer.
US 2017/186715 A1 describes methods for forming bond structures.
US 2021/287994 A1 describes a semiconductor structure including an inter-level dielectric layer overlying a substrate.
US 2017/117253 A1 describes a chip package including a semiconductor chip and a semiconductor die over the semiconductor chip.
US 2022/068826 A1 describes methods for forming a via.
US 2008/079154 A1 describes a laminated structure and a method for its fabrication.
US 2016/381795 A1 describes an electronic device and a method for manufacturing the electronic device.
US 2014/217593 A1 describes an electrical connecting element for connecting a first substrate and a second substrate.
US 2016/013135 A1 describes a method for fabricating a semiconductor structure.

With development in the field of semiconductor technologies, people pose increasingly high requirements on integration of integrated circuits. A three-dimensional integrated circuit (Three Dimensional Integrated Circuit, 3D IC for short) is prepared by using a hybrid bonding (Hybrid Bonding) process. This can implement a small size and high density of the three-dimensional integrated circuit.

At present, hybrid bonding of wafers with different functions, different manufacturing processes, and different sizes for implementing three-dimensional integration has become a mainstream development trend of the three-dimensional integrated circuit. Connection patterns and dielectric bonding layers are made on surfaces of two wafers to be bonded. During hybrid bonding, the connection patterns of the two wafers are bonded, and the dielectric bonding layers of the two wafers are bonded. In view of this, how to improve quality of an electrical connection and strength of a mechanical connection between the connection patterns of the two wafers, to improve product reliability of the three-dimensional integrated circuit formed through bonding becomes a problem to be urgently resolved in this field.

### SUMMARY

Some embodiments of this application provide an integrated circuit and a preparation method thereof, a three-dimensional integrated circuit, and an electronic device according to the independent claims, to improve product reliability of the three-dimensional integrated circuit.

To achieve the foregoing objectives, the following technical solutions are used in embodiments of this application.

According to a first aspect, an integrated circuit is provided. The integrated circuit includes a substrate, an electronic component, a wiring layer, a dielectric bonding layer, a connection pattern, and a barrier layer. The electronic component is disposed on the substrate. The wiring layer is disposed on the substrate, and is electrically connected to the electronic component. The wiring layer includes a metal trace. The dielectric bonding layer is disposed on a side that is of the wiring layer and that is away from the substrate. The connection pattern runs through the dielectric bonding layer, and is electrically connected to the metal trace. The connection pattern includes a seed layer and a conductive block that are stacked, and the seed layer is located on a side that is of the conductive block and that is close to the substrate. The barrier layer is disposed between the conductive block and the dielectric bonding layer, and surrounds a side surface of the conductive block.

According to the integrated circuit provided in the foregoing embodiment of this application, the seed layer is located on the side that is of the conductive block and that is close to the substrate, that is, the seed layer is disposed at the bottom of the conductive block, and the seed layer is not disposed on the side surface of the conductive block. That is, in a process of preparing the integrated circuit, an opening is first formed in the dielectric bonding layer, and then the seed layer is formed at the bottom of the opening. The seed layer is not disposed on a side wall of the opening, and copper is deposited on a surface of the seed layer to form the conductive block. Because the seed layer is disposed at the bottom of the opening, most regions of the surface of the seed layer are parallel to an upper surface of the conductive block (a surface on a side that is of the conductive block and that is away from the substrate). This can improve consistency of distribution of specific crystal faces on the upper surface of the conductive block, increase an area proportion of a (111) crystal face on the upper surface of the conductive block, and facilitate good bonding between conductive blocks at a lower annealing temperature, thereby improving product reliability after bonding of the integrated circuit.

In addition, the barrier layer is disposed between the conductive block and the dielectric bonding layer, and the barrier layer surrounds the side surface of the conductive block. This can avoid copper diffusion caused by direct contact between the conductive block and the dielectric bonding layer, thereby further improving product reliability of the integrated circuit.

In some embodiments, the barrier layer is further disposed between the seed layer and the dielectric bonding layer, and surrounds a side surface of the seed layer.

In the foregoing embodiment, the barrier layer surrounds the side surface of the seed layer, and the barrier layer can separate the seed layer from the dielectric bonding layer. This can avoid copper diffusion caused by direct contact between the seed layer and the dielectric bonding layer, thereby improving product reliability of the integrated circuit.

In an example, which is not an embodiment of the present invention but helpful for understanding certain aspects thereof, the barrier layer is further disposed between the adhesive layer and the dielectric bonding layer, and surrounds a side surface of the adhesive layer.

In the foregoing embodiment, the adhesive layer is disposed on the side that is of the seed layer and that is close to the substrate, and the adhesive layer may be used to adhere to the seed layer. In addition, the barrier layer surrounds the side surface of the adhesive layer, and the barrier layer can separate the adhesive layer from the dielectric bonding layer. This can avoid diffusion caused by direct contact between the adhesive layer and the dielectric bonding layer, thereby improving product reliability of the integrated circuit.

The connection pattern further includes an adhesive layer, the adhesive layer is disposed on a side that is of the seed layer and that is close to the substrate, and the dielectric bonding layer covers a side surface of the adhesive layer.

In the foregoing embodiment, a material of the adhesive layer is different from a material of the seed layer and a material of the conductive block, and the material of the seed layer and the material of the conductive block are the same. In view of this, in a process of preparing the barrier layer by using a selective deposition process, to ensure that the barrier layer is formed on the surface of the seed layer and the surface of the conductive block, a rate at which the material of the barrier layer is deposited on the surface of the seed layer and the surface of the conductive block needs to be controlled to be greater than a rate at which the material of the barrier layer is deposited on the surface of the adhesive layer. Therefore, there is a case where the side surface of the adhesive layer is not surrounded by the barrier layer, and after the dielectric bonding layer is formed, the dielectric bonding layer covers the side surface of the adhesive layer.

A material of the adhesive layer includes at least one of Ti, TiN, Ta, and TaN.

In the foregoing embodiment, the adhesive layer has adhesive force by selecting the material of the adhesive layer.

A material of the barrier layer includes at least one of Co, CoP, CoWP, CoB, CoWB, Ni, NiP, NiWP, NiMoP, NiB, and NiMoB.

In the foregoing embodiment, the barrier layer has good barrier effect by selecting the material of the barrier layer.

In some embodiments, the integrated circuit further includes an insulation layer and a conductive structure, and the insulation layer is disposed between the wiring layer and the connection pattern. The conductive structure runs through the insulation layer, one end of the conductive structure is electrically connected to the metal trace, and the other end is electrically connected to the connection pattern.

In the foregoing embodiment, the conductive structure can implement an electrical connection between the metal trace and the connection pattern.

In some embodiments, an end face that is of the conductive structure and that is connected to the connection pattern is coplanar with a surface on a side that is of the insulation layer and that is away from the substrate.

In the foregoing embodiment, the surface on the side that is of the insulation layer and that is away from the substrate is flat. In the process of preparing the integrated circuit, the seed layer is formed on the surface of the insulation layer, and then copper is deposited on the surface of the seed layer to form the conductive block. Because the seed layer is disposed on the flat surface, the surface of the seed layer is parallel to the upper surface of the conductive block. This can further increase the area proportion of the (111) crystal face on the upper surface of the conductive block, and facilitate good bonding between the conductive blocks at a lower annealing temperature.

In some embodiments, a material of the conductive block includes copper, and the area proportion of the (111) crystal face on the surface on the side that is of the conductive block and that is away from the substrate is greater than or equal to 80%. This can ensure good bonding between the conductive blocks at a lower annealing temperature.

In some embodiments, the integrated circuit further includes a virtual connection pattern and a virtual barrier layer. The virtual connection pattern runs through the dielectric bonding layer. The virtual connection pattern includes a virtual seed layer and a virtual conductive block that are stacked, and the virtual seed layer is located on a side that is of the virtual conductive block and that is close to the substrate. The virtual barrier layer is disposed between the virtual conductive block and the dielectric bonding layer, and surrounds a side surface of the virtual conductive block. The virtual seed layer and the seed layer of the connection pattern are made of a same material and disposed at a same layer, the virtual conductive block and the conductive block of the connection pattern are made of a same material and disposed at a same layer, and the virtual barrier layer and the barrier layer are made of a same material and disposed at a same layer.

In the foregoing disposing manner, a virtual adhesive layer and the adhesive layer can be formed in a same preparation process step; the virtual seed layer and the seed layer can be formed in a same preparation process step; the virtual conductive block and the conductive block can be formed in a same preparation process step; and the virtual barrier layer and the barrier layer can be formed in a same preparation process step.

In addition, the virtual connection pattern is disposed on the surface of the integrated circuit, and the virtual connection pattern and the connection pattern are evenly distributed on the surface of the integrated circuit. This can improve uniformity of structural strength of the surface of the integrated circuit. In the process of preparing the integrated circuit, the surface of the integrated circuit is polished. Uniformity of polishing can be improved by improving the uniformity of the structural strength of the integrated circuit, thereby improving polishing quality and flatness of the surface of the integrated circuit.

According to a second aspect, an integrated circuit preparation method is provided. The preparation method includes: forming a wiring layer on a substrate, where the wiring layer includes a metal trace; forming a seed thin film, where the seed thin film is located on a side that is of the wiring layer and that is away from the substrate; forming a mask layer, where the mask layer is located on a side that is of the seed thin film and that is away from the substrate, the mask layer has an opening, and the opening exposes a specified region of the seed thin film; forming a conductive block in the opening; removing the mask layer; and forming a barrier layer and a dielectric bonding layer, where the barrier layer surrounds a side surface of the conductive block, and the dielectric bonding layer is located on a side that is of the barrier layer and that is away from the conductive block.

According to the preparation method provided in the foregoing embodiment of this application, the seed thin film is first formed, and then the mask layer having the opening is formed on the seed thin film, so that the seed thin film is located at the bottom of the opening, and is not located on a side wall of the opening. In this way, in a process of forming the conductive block in the opening, because the seed thin film is disposed at the bottom of the opening, most regions of a surface of the seed thin film are parallel to an upper surface of the conductive block. This can improve consistency of distribution of specific crystal faces on the upper surface of the conductive block, increase an area proportion of a (111) crystal face on the upper surface of the conductive block, and facilitate good bonding between conductive blocks at a lower annealing temperature, thereby improving product reliability after bonding of the integrated circuit.

In addition, the barrier layer surrounding the side surface of the conductive block is formed. This can avoid copper diffusion caused by direct contact between the conductive block and the dielectric bonding layer, thereby further improving product reliability of the integrated circuit.

The forming a barrier layer and a dielectric bonding layer includes: forming a barrier thin film covering the conductive block; forming a dielectric thin film covering the barrier thin film; and removing a part on a side that is of the dielectric thin film and that is away from the substrate, and a part of the barrier thin film located on a side that is of the conductive block and that is away from the substrate, to expose the conductive block, and to facilitate bonding between conductive blocks of the integrated circuit.

The forming a barrier thin film covering the conductive block includes: forming, by using a selective deposition process, the barrier thin film on the side surface of the conductive block and a surface on the side that is of the conductive block and that is away from the substrate. This simplifies a preparation process.

After the removing the mask layer and before the forming a barrier thin film covering the conductive block, the method further includes: etching, by using the conductive block as a mask, a part that is of the seed thin film and that is not shielded by the conductive block, to form a seed layer. The barrier thin film further covers a side surface of the seed layer.

In the foregoing embodiment, the conductive block is used as the mask for etching the seed thin film. This can avoid adding the mask layer for etching the seed thin film, and simplify the preparation process. In addition, the barrier thin film further covers the side surface of the seed layer. This can avoid copper diffusion caused by subsequent direct contact between the seed layer and the dielectric bonding layer, thereby improving product reliability of the integrated circuit.

After the forming a wiring layer on a substrate and before the forming a seed thin film, the method further includes: forming an adhesive thin film, where the adhesive thin film is located on the side that is of the wiring layer and that is away from the substrate. In a process of etching the part that is of the seed thin film and that is not shielded by the conductive block, a part that is of the adhesive thin film and that is not shielded by the conductive block is further etched, to form an adhesive layer. Further, a material of the adhesive layer comprises at least one of Ti, TiN, Ta, and TaN; and a material of the barrier layer comprises at least one of Co, CoP, CoWP, CoB, CoWB, Ni, NiP, NiWP, NiMoP, NiB, and NiMoB. Moreover, in the selective deposition process a rate at which the material of the barrier thin film is deposited on the side surface of the seed layer and the side surface of the conductive block is controlled to be greater than a rate at which the material of the barrier thin film is deposited on the side surface of the adhesive layer so that, after the dielectric bonding layer is formed, the dielectric bonding layer covers a side surface of the adhesive layer.

In the foregoing embodiment, the conductive block is used as the mask for etching the adhesive thin film. This can avoid adding the mask layer for etching the adhesive thin film, and simplify the preparation process. In addition, the barrier thin film further covers the side surface of the adhesive layer. This can avoid copper diffusion caused by subsequent direct contact between the adhesive layer and the dielectric bonding layer, thereby improving product reliability of the integrated circuit.

In some embodiments, after the forming a wiring layer on a substrate and before the forming a seed thin film, the method further includes: forming an insulation layer covering the wiring layer; and forming a conductive structure, where the conductive structure runs through the insulation layer, and one end of the conductive structure is electrically connected to the metal trace.

In the foregoing embodiment, a surface on the side that is of the insulation layer and that is away from the substrate is flat, and the adhesive thin film and the seed thin film are formed on the surface of the insulation layer, so that surfaces of the adhesive thin film and the seed thin film are flat, and copper is deposited on the surface of the seed thin film to form the conductive block, so that the area proportion of the (111) crystal face on the upper surface of the conductive block is higher, thereby facilitating good bonding between the conductive blocks at a lower annealing temperature.

According to a third aspect, a three-dimensional integrated circuit is provided. The three-dimensional integrated circuit includes a first integrated circuit and a second integrated circuit that are disposed opposite to each other, and both the first integrated circuit and the second integrated circuit are the integrated circuit according to any one of the foregoing embodiments. A connection pattern of the first integrated circuit is bonded with a connection pattern of the second integrated circuit, and a dielectric bonding layer of the first integrated circuit is bonded with a dielectric bonding layer of the second integrated circuit, to implement bonding between the first integrated circuit and the second integrated circuit.

In some embodiments, the connection pattern of the first integrated circuit is not in contact with the dielectric bonding layer of the second integrated circuit.

In the foregoing embodiment, in the two bonded integrated circuits, the connection patterns are not in contact with the dielectric bonding layers. This can avoid copper diffusion easily caused by direct contact between the connection pattern and the dielectric bonding layer, thereby improving product reliability of the three-dimensional integrated circuit.

In some embodiments, both a thickness of a barrier layer of the first integrated circuit and a thickness of a barrier layer of the second integrated circuit are greater than or equal to an alignment limit deviation for performing hybrid bonding between the first integrated circuit and the second integrated circuit.

In the foregoing embodiment, the thickness of the barrier layer is set to be greater than or equal to the alignment limit deviation between the first integrated circuit and the second integrated circuit. This can ensure that a connection pattern of one integrated circuit is not in contact with a dielectric bonding layer of the other integrated circuit, thereby improving product reliability of the three-dimensional integrated circuit.

According to a fourth aspect, a three-dimensional integrated circuit preparation method is provided. The preparation method is applied to preparing the three-dimensional integrated circuit according to any one of the foregoing embodiments, and the preparation method includes: attaching a first integrated circuit to a second integrated circuit in alignment; and performing annealing treatment on the first integrated circuit and the second integrated circuit that are attached, where a temperature of the annealing treatment is less than or equal to 300°C, to implement bonding between the first integrated circuit and the second integrated circuit.

In some embodiments, before the attaching a first integrated circuit to a second integrated circuit in alignment, the method further includes: performing activation treatment and hydrophilicity treatment on an attachment surface between the first integrated circuit and the second integrated circuit.

In the foregoing embodiment, the activation treatment can remove impurities on the attachment surface and an oxide layer of copper on a connection pattern surface of the integrated circuit. The hydrophilicity treatment can increase strength of bonding between dielectric bonding layers of the first integrated circuit and the second integrated circuit.

According to a fifth aspect, an electronic device is provided. The electronic device includes a circuit board and the three-dimensional integrated circuit according to any one of the foregoing embodiments. The three-dimensional integrated circuit is electrically connected to the circuit board.

It may be understood that, for beneficial effect that can be achieved by the electronic device provided in the foregoing embodiment of this disclosure, refer to the beneficial effect of the foregoing integrated circuit. Details are not described herein again.

### BRIEF DESCRIPTION OF DRAWINGS

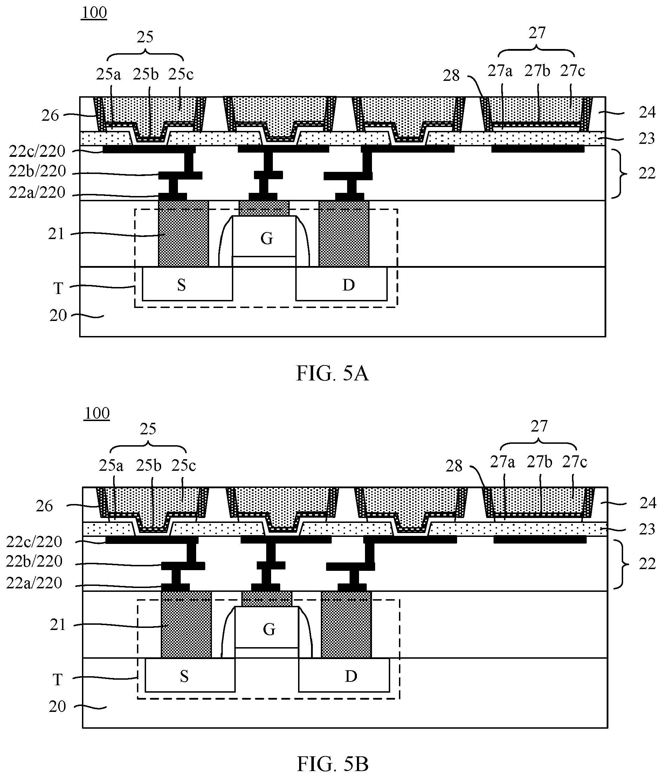

To describe the technical solutions in this disclosure more clearly, the following briefly describes the accompanying drawings for describing some embodiments of this disclosure. It is clear that the accompanying drawings in the following description show merely some embodiments of this disclosure, and a person of ordinary skill in the art may still derive other drawings from these accompanying drawings. In addition, the accompanying drawings in the following description may be considered as diagrams, and are not intended to limit an actual size of a product, an actual procedure of a method, an actual time sequence of a signal, and the like in embodiments of this disclosure. The diagrams shown in the following figures 5A, 7I to 7K and 8 are not according to the present invention but helpful for understanding certain aspects thereof.
FIG. 1 is a diagram of a structure of an electronic device according to some embodiments;
FIG. 2 is a diagram of a structure of a three-dimensional integrated circuit 16 according to some embodiments;
FIG. 3 is a top view of an integrated circuit in a related technology;
FIG. 4 is a sectional view of the integrated circuit in FIG. 3 along a sectional line A-A';
FIG. 5A is a diagram of a structure of an integrated circuit according to some embodiments;
FIG. 5B is a diagram of a structure of another integrated circuit according to some embodiments;
FIG. 6A to FIG. 6E are flowcharts of preparing an integrated circuit according to some embodiments;
FIG. 7A to FIG. 7K are diagrams of steps of preparing an integrated circuit according to some embodiments;
FIG. 8 is a diagram of a structure of another integrated circuit according to some embodiments;
FIG. 9 is a flowchart of preparing another integrated circuit according to some embodiments;
FIG. 10A to FIG. 10D are diagrams of steps of preparing an integrated circuit according to some embodiments;
FIG. 11A is a diagram of a structure of a three-dimensional integrated circuit according to some embodiments;
FIG. 11B is a diagram of a structure of another three-dimensional integrated circuit according to some embodiments; and
FIG. 12 is a diagram of bonding between a first integrated circuit and a second integrated circuit according to some embodiments.

### DESCRIPTION OF EMBODIMENTS

The technical solutions in some embodiments of this disclosure will be clearly described in the following with reference to the accompanying drawings. It is obvious that the embodiments to be described are only some rather than all of the embodiments of this disclosure. All other embodiments obtained by a person of ordinary skill in the art based on embodiments of this disclosure fall within the protection scope of this disclosure.

In the descriptions of this disclosure, it should be understood that, position or location relationships indicated by the terms "center", "upper", "lower", "ahead", "behind", "left", "right", "perpendicular", "horizontal", "top", "bottom", "inner", "outer", and the like are position or location relationships based on the accompanying drawings, and are merely intended for ease of describing this disclosure and simplification of description, instead of indicating or implying that the apparatuses or components referred to need to be provided in a particular position or be constructed and operated in a particular position, and therefore, shall not be understood as limitations on this disclosure.

Unless otherwise specified in the context, in the entire specification and claims, the term "include" is interpreted as "open and inclusive", that is, "include, but not limited to". In the descriptions of the specification, terms such as "an embodiment", "some embodiments", "example embodiments", "examples", or "some examples" are intended to indicate that specific features, structures, materials, or features related to embodiments or examples are included in at least one embodiment or example of this disclosure. The foregoing schematic representations of the terms do not necessarily refer to a same embodiment or example. Further, the particular feature, structure, material, or characteristic may be included in any one or more embodiments or examples in any appropriate manner.

Terms "first" and "second" mentioned below are merely intended for a purpose of description, and shall not be understood as an indication or implication of relative importance or implicit indication of a quantity of indicated technical features. Therefore, a feature limited by "first" or "second" may explicitly or implicitly include one or more features. In the description of embodiments of this disclosure, unless otherwise specified, "a plurality of" means two or more.

When some embodiments are described, expressions of "connection" and its extensions may be used. For example, when some embodiments are described, the term "connection" may be used to indicate that two or more parts are in direct physical contact or electrical contact with each other.

"A and/or B" includes the following three combinations: only A, only B, and a combination of A and B.

In addition, the use of "based on" means openness and inclusiveness, since processes, steps, calculation, or other actions "based on" one or more of conditions or values may be based in practice on additional conditions or values outside the described values.

Example implementations are described herein with reference to sectional views and/or plane diagrams that are used as idealized example accompanying drawings. In the accompanying drawings, for clarity, thicknesses of layers and regions are increased. Thus, a change in a shape in the accompanying drawings due to, for example, manufacturing techniques and/or tolerances may be envisaged. Therefore, example implementations should not be construed as being limited to a shape of a region shown herein, but rather include shape deviations due to, for example, manufacturing. For example, an etching region shown as a rectangle typically has a bending characteristic. Therefore, the regions shown in the accompanying drawings are essentially examples, and their shapes are not intended to show actual shapes of regions of a device, and are not intended to limit a scope of the example implementations.

Embodiments of this application provide an electronic device. The electronic device may be different types of user equipment or terminal devices, for example, a mobile phone, a tablet computer, a personal digital assistant (Personal Digital Assistant, PDA for short), a television, an intelligent wearable product (for example, a smartwatch or a smart band), a virtual reality (Virtual Reality, VR for short) terminal device, an augmented reality (Augmented Reality, AR for short) terminal device, a charging home small appliance (for example, a soybean milk machine or a robot vacuum cleaner), an uncrewed aerial vehicle, a radar, an aerospace device, and a vehicle-mounted device. A specific form of the electronic device is not specially limited in this embodiment of this application.

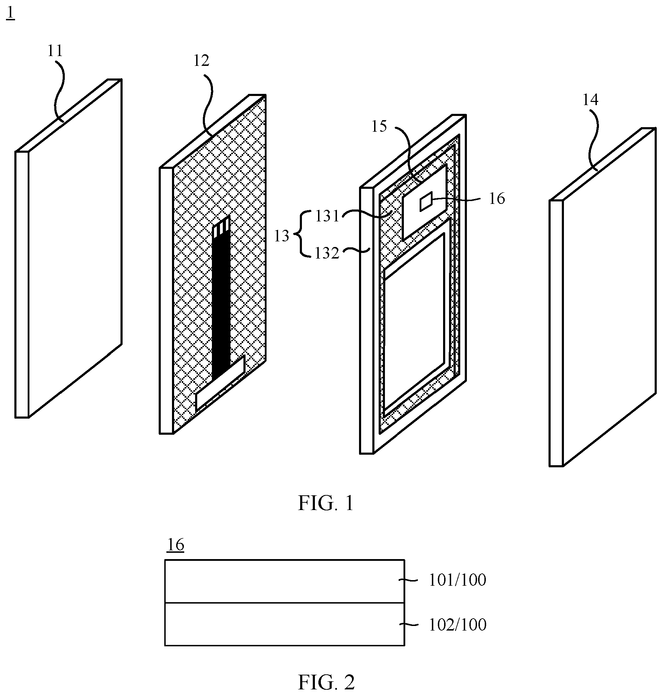

For ease of description, the following uses an example in which an electronic device is a mobile phone for description. FIG. 1 is a diagram of a structure of an electronic device according to some embodiments.

As shown in FIG. 1, an electronic device 1 mainly includes a cover 11, a display 12, a middle frame 13, and a rear housing 14. The rear housing 14 and the display 12 are respectively located on two sides of the middle frame 13, the middle frame 13 and the display 12 are disposed in the rear housing 14, the cover 11 is disposed on a side that is of the display 12 and that is away from the middle frame 13, and a display surface of the display 12 faces the cover 11.

The display 12 may be a liquid crystal display (Liquid Crystal Display, LCD for short). In this case, the liquid crystal display includes a liquid crystal display panel and a backlight module. The liquid crystal display panel is disposed between the cover 11 and the backlight module, and the backlight module is configured to provide a light source for the liquid crystal display panel. The display 12 may alternatively be an organic light emitting diode (Organic Light Emitting Diode, OLED for short) display. Because the OLED display is a self-luminous display, no backlight module needs to be disposed.

The middle frame 13 includes a bearing plate 131 and a bezel 132 around the bearing plate 131. The electronic device 1 further includes electronic components such as a circuit board 15, a battery, and a camera that are disposed on the bearing plate 131.

As shown in FIG. 1, the electronic device 1 may further include a three-dimensional integrated circuit 16 disposed on the circuit board 15, and the three-dimensional integrated circuit 16 is electrically connected to the circuit board 15.

FIG. 2 is a diagram of a structure of a three-dimensional integrated circuit 16 according to some embodiments.

Refer to FIG. 2. The three-dimensional integrated circuit 16 includes at least two integrated circuits 100. For example, the at least two integrated circuits 100 include a first integrated circuit 101 and a second integrated circuit 102 that are disposed opposite to each other. Both the first integrated circuit 101 and the second integrated circuit 102 may be wafers, or both may be chips, or one is a wafer and the other is a chip. This is not limited in this embodiment of this application.

A connection pattern and a dielectric bonding layer are made on surfaces of both the first integrated circuit 101 and the second integrated circuit 102. A hybrid bonding process is used for bonding between the connection pattern of the first integrated circuit 101 and the connection pattern of the second integrated circuit 102, and bonding between the dielectric bonding layer of the first integrated circuit 101 and the dielectric bonding layer of the second integrated circuit 102.

Currently, in a hybrid bonding process, high-temperature annealing treatment needs to be performed on two integrated circuits 100 connected through bonding, and annealing temperatures are usually between 350°C and 400°C, to increase strength of a mechanical connection between the two integrated circuits and reduce contact resistance of a bonding interface between connection patterns of the two integrated circuits. However, because stability of an electronic component in the integrated circuit 100 is poor in a high-temperature environment, a high temperature in an annealing treatment process may cause performance degradation of the electronic component. Therefore, a low-temperature hybrid bonding technology is urgently needed to avoid impact of a high temperature on performance of the electronic device.

Generally, a material of the connection pattern of the integrated circuit 100 mainly includes copper. Copper is a polycrystalline metal, and has a plurality of crystal faces. In the hybrid bonding process, there are different diffusivities between copper with different crystal faces on bonded connection pattern surfaces. It may be understood that a higher diffusivity between copper can make strength of a mechanical connection and quality of an electrical connection between the connection patterns higher, to implement good bonding between the connection patterns.

Table 1 below shows diffusivities between copper with a (111) crystal face, copper with a (100) crystal face, and copper with a (110) crystal face at different temperatures.

**Table 1**

| D_{surf.}\ Temp. | (111) | (100) | (110) |
|---|---|---|---|
| 300°C | 1.51×10⁻⁵ | 1.48×10⁻⁸ | 1.55×10⁻⁹ |
| 250°C | 1.22×10⁻⁵ | 4.74×10⁻⁹ | 3.56×10⁻¹⁰ |
| 200°C | 9.42×10⁻⁶ | 1.19×10⁻⁹ | 5.98×10⁻¹⁰ |
| 150°C | 6.85×10⁻⁶ | 2.15×10⁻¹⁰ | 6.61×10⁻¹² |

"D_{surf.}" indicates a surface diffusivity (surface diffusivity), and the unit of the surface diffusivity is square centimeter/second ( *cm*² / sec ). "Temp." indicates the temperature (temperature).

It can be seen from Table 1 that, when the annealing temperature ranges from 150°C to 300°C, the diffusivity between copper with the (111) crystal face is greater than the diffusivity between copper with the (100) crystal face and greater than the diffusivity between copper with the (110) crystal face. Therefore, good bonding between the connection patterns can be implemented at a lower annealing temperature by forming the copper with the (111) crystal face on the connection pattern surface.

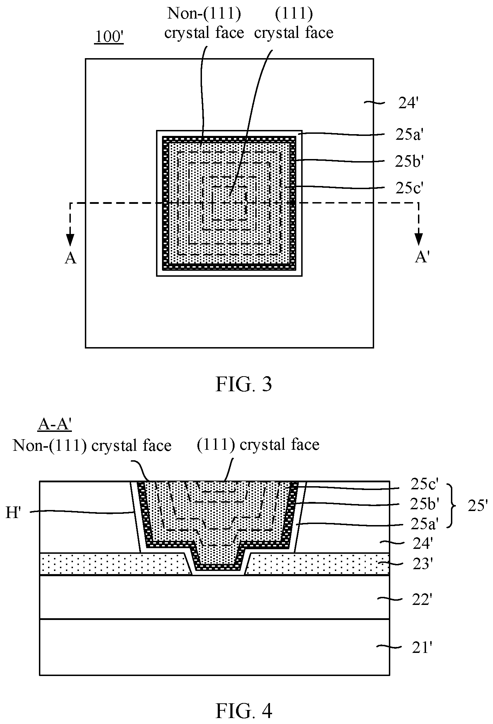

In view of this, in the related technology, an integrated circuit and a preparation method thereof are provided. FIG. 3 is a top view of the integrated circuit in the related technology; and FIG. 4 is a sectional view of the integrated circuit in FIG. 3 along a sectional line A-A'.

Refer to FIG. 3 and FIG. 4. An integrated circuit 100' includes a substrate 21', a wiring layer 22', an insulation layer 23', a dielectric bonding layer 24', and a connection pattern 25' that are sequentially stacked.

The connection pattern 25' runs through the dielectric bonding layer 24' and the insulation layer 23', and is electrically connected to the wiring layer 22'. The connection pattern 25' includes an adhesive layer 25a', a seed layer 25b', and a conductive block 25c'.

In a process of preparing the integrated circuit 100', the wiring layer 22', the insulation layer 23', and the dielectric bonding layer 24' are sequentially formed on the substrate 21', and the dielectric bonding layer 24' and the insulation layer 23' are etched to form an opening. The opening runs through the dielectric bonding layer 24' and the insulation layer 23', and exposes the wiring layer 22'. Then, the adhesive layer 25a' and the seed layer 25b' are formed in the opening, and the adhesive layer 25a' and the seed layer 25b' cover a side wall and the bottom of the opening. Further, copper is deposited on a surface of the seed layer 25b' in the opening by using an electroplating process, to form the conductive block 25c'.

It is found through research that, in a process of depositing copper on a surface of the seed layer 25b', a (111) crystal face of copper is parallel to the surface of the seed layer 25b'. Refer to FIG. 4. Because a side wall of an opening H' is inclined, and is not parallel to an upper surface of the conductive block 25c', a surface of the part that is of the seed layer 25b' and that covers the side wall of the opening H' is also inclined, and is not parallel to the upper surface of the conductive block 25c'. In this way, the (111) crystal face of the copper near the side wall of the opening H' is not parallel to the upper surface of the conductive block 25c', that is, on the upper surface of the conductive block 25c', copper near the side wall (an edge region) of the opening H' exposes a non-(111) crystal face, and copper far away from the side wall (a central region) of the opening H' exposes a (111) crystal face.

Copper with the non-(111) crystal face existing on the upper surface of the conductive block 25c' is not conducive to implementing good bonding between conductive blocks 25c' at a lower annealing temperature. In addition, refer to FIG. 3. When a plane size of the integrated circuit 100' is small, an area proportion of a (111) crystal face on the upper surface of the conductive block 25c' is reduced, and bonding quality between the conductive blocks 25c' is further reduced.

To resolve the foregoing problem, some embodiments of this application provide an integrated circuit. FIG. 5A is a diagram of a structure of an integrated circuit according to some embodiments. FIG. 5B is a diagram of a structure of another integrated circuit according to some embodiments.

Refer to FIG. 5A. An integrated circuit 100 includes a substrate 20 and an electronic component T disposed on the substrate 20.

For example, the electronic component T may include a transistor, a capacitor, an inductor, and the like. The electronic device T in FIG. 5A is described by using a transistor as an example. The transistor includes a gate G, a source S, and a drain D.

In addition, the integrated circuit 100 further includes a conductive pattern 21, and one end of the conductive pattern 21 is electrically connected to the electronic device T. For example, a gate G, a source S, and a drain D of a transistor are respectively corresponding to and electrically connected to one conductive pattern 21.

Refer to FIG. 5A. The integrated circuit 100 further includes a wiring layer 22 disposed on the substrate 20. The wiring layer 22 is electrically connected to the electronic component T, and the wiring layer 22 includes a metal trace 220.

For example, the wiring layer 22 includes a plurality of conductive layers. The plurality of conductive layers may include, for example, a first conductive layer 22a, a second conductive layer 22b, and a third conductive layer 22c, and each conductive layer includes a metal trace 220. The metal trace 220 in the first conductive layer 22a is electrically connected to the electronic device T by using the conductive pattern 21.

Refer to FIG. 5A. The integrated circuit 100 further includes a dielectric bonding layer 24, a connection pattern 25, and a barrier layer 26. The dielectric bonding layer 24 is disposed on a side that is of the wiring layer 22 and that is away from the substrate 20, and the connection pattern 25 runs through the dielectric bonding layer 24, and is electrically connected to the metal trace 220 in the wiring layer 22.

For example, the connection pattern 25 is electrically connected to the metal trace 220 in the third conductive layer 22c of the wiring layer 22.

Refer to FIG. 5A. The connection pattern 25 includes a seed layer 25b and a conductive block 25c that are stacked, and the seed layer 25b is located on a side that is of the conductive block 25c and that is close to the substrate 20. The barrier layer 26 is disposed between the conductive block 25c and the dielectric bonding layer 24, and surrounds a side surface of the conductive block 25c.

It should be noted that, during hybrid bonding of two integrated circuits 100, a connection pattern 25 (a conductive block 25c) of one integrated circuit 100 is bonded with a connection pattern 25 (a conductive block 25c) of the other integrated circuit 100, to implement an electrical connection between the two integrated circuits 100. In addition, a dielectric bonding layer 24 of one integrated circuit 100 is bonded with a dielectric bonding layer 24 of another integrated circuit 100.

A material of the seed layer 25b includes copper, which can be used as a base metal to be plated. During electroplating, copper is deposited on the surface of the seed layer 25b to form the conductive block 25c. Generally, an average diameter of grains of copper in the seed layer 25b is smaller than an average diameter of grains of copper in the conductive block 25c. The material of the barrier layer 26 includes at least one of Co, CoP, CoWP, CoB, CoWB, Ni, NiP, NiWP, NiMoP, NiB, and NiMoB, so that the barrier layer 26 has good barrier effect.

In addition, "a side surface of the conductive block 25c" is a surface on a side that is of the conductive block 25c and that is close to the dielectric bonding layer 24.

For example, the connection pattern 25 further includes an adhesive layer 25a, and the adhesive layer 25a is disposed on a side that is of the seed layer 25b and that is close to the substrate 20.

It should be noted that, as shown in FIG. 5A, the integrated circuit 100 further includes an insulation layer 23. The insulation layer 23 is disposed on a side that is of the wiring layer 22 and that is away from the substrate 20. A material of the insulation layer 23 may be the same as a material of the dielectric bonding layer 24. The connection pattern 25 runs through the insulation layer 23, and is electrically connected to the metal trace 220 in the wiring layer 22.

The adhesive layer 25a is disposed on the side that is of the seed layer 25b and that is close to the substrate 20, and the adhesive layer 25a may adhere the seed layer 25b to the insulation layer 23, thereby ensuring a stable connection between the seed layer 25b and the conductive block 25c and the insulation layer 23. In addition, the adhesive layer 25a can separate the seed layer 25b from the insulation layer 23. This can avoid copper diffusion caused by direct contact between the seed layer 25b and the insulation layer 23, thereby improving product reliability of the integrated circuit 100.

For example, a material of the adhesive layer 25a includes at least one of Ti, TiN, Ta, and TaN, so that the adhesive layer 25a has adhesive force.

According to the integrated circuit 100 provided in the foregoing embodiment of this application, the seed layer 25b is located on the side that is of the conductive block 25c and that is close to the substrate 20, that is, the seed layer 25b is disposed at the bottom of the conductive block 25c, and the side surface of the conductive block 25c is not provided with the seed layer 25b. That is, in a process of preparing the integrated circuit 100, the seed layer 25b is first formed, and copper is deposited on the surface of the seed layer 25b to form the conductive block 25c. Because the seed layer 25b is disposed at the bottom of the conductive block 25c, most regions of the surface of the seed layer 25b are parallel to an upper surface of the conductive block 25c (a surface on a side that is of the conductive block 25c and that is away from the substrate 20). This can improve consistency of distribution of specific crystal faces on the upper surface of the conductive block 25c, increase an area proportion of a (111) crystal face on the upper surface of the conductive block 25c, and facilitate good bonding between conductive blocks 25c at a lower annealing temperature, thereby improving product reliability after bonding of the integrated circuit 100.

The inventor of this application finds that a material of the dielectric bonding layer 24 may be an inorganic dielectric material or an organic dielectric material. The inorganic dielectric material may include, for example, silicon oxide, silicon nitride, or silicon oxynitride, and the organic dielectric material may include, for example, polyimide. The dielectric bonding layer 24 may alternatively be a stacked structure. For example, the dielectric bonding layer 24 includes a silicon oxide layer and a silicon nitride layer that are stacked. Copper diffusion may easily occur in direct contact between the conductive block 25c and the dielectric bonding layer 24, copper in the conductive block 25c diffuses into the dielectric bonding layer 24, and electromigration occurs between adjacent conductive blocks 25c, resulting in a product reliability problem. In addition, copper diffusion also causes a hole in the conductive block 25c. This leads to an increase in resistance of the conductive block 25c, and further increases a transmission loss of the electrical signal on the conductive block 25c.

In view of this, in the foregoing embodiment of this application, the barrier layer 26 is disposed between the conductive block 25c and the dielectric bonding layer 24, and the barrier layer 26 surrounds the side surface of the conductive block 25c. This can avoid copper diffusion caused by direct contact between the conductive block 25c and the dielectric bonding layer 24, thereby further improving product reliability of the integrated circuit 100.

In some embodiments, refer to FIG. 5A. The barrier layer 26 is further disposed between the seed layer 25b and the dielectric bonding layer 24, and the barrier layer 26 surrounds a side surface of the seed layer 25b.

It should be noted that "a side surface of the seed layer 25b" is a surface on a side that is of the seed layer 25b and that is close to the dielectric bonding layer 24.

In addition, because a material of the seed layer 25b includes copper, copper diffusion may also easily occur in direct contact between the seed layer 25b and the dielectric bonding layer 24, and a hole is formed in the seed layer 25b. This leads to an increase in resistance of the seed layer 25b, and in a process in which an electrical signal is transmitted from the connection pattern 25 to the metal trace 220, a transmission loss on the seed layer 25b increases.

However, in the foregoing embodiment of this application, the barrier layer 26 surrounds the side surface of the seed layer 25b, and the barrier layer 26 can separate the seed layer 25b from the dielectric bonding layer 24, to avoid copper diffusion caused by direct contact between the seed layer 25b and the dielectric bonding layer 24, thereby improving product reliability of the integrated circuit 100.

In some embodiments, refer to FIG. 5A. The barrier layer 26 is further disposed between the adhesive layer 25a and the dielectric bonding layer 24, and the barrier layer 26 surrounds a side surface of the adhesive layer 25a.

It should be noted that "a side surface of the adhesive layer 25a" is a surface on a side that is of the adhesive layer 25a and that is close to the dielectric bonding layer 24.

Because a material of the adhesive layer 25a is also a metal material, metal diffusion may also occur during direct contact between the adhesive layer 25a and the dielectric bonding layer 24. The barrier layer 26 surrounds the side surface of the adhesive layer 25a, and the barrier layer 26 can separate the adhesive layer 25a from the dielectric bonding layer 24. This can avoid diffusion caused by direct contact between the adhesive layer 25a and the dielectric bonding layer 24, thereby improving product reliability of the integrated circuit 100.

In some embodiments, refer to FIG. 5B. The dielectric bonding layer 24 covers a side surface of the adhesive layer 25a. In other words, the barrier layer 26 may not surround a side surface of the adhesive layer 25a.

It should be noted that a material of the adhesive layer 25a is different from a material of the seed layer 25b and a material of the conductive block 25c, and the material of the seed layer 25b and the material of the conductive block 25c are the same. In view of this, in a process of preparing the barrier layer 26 by using a selective deposition process, to ensure that the barrier layer 26 is formed on the surface of the seed layer 25b and the surface of the conductive block 25c, a rate at which the material of the barrier layer 26 is deposited on the surface of the seed layer 25b and the surface of the conductive block 25c needs to be controlled to be greater than a rate at which the material of the barrier layer 26 is deposited on the surface of the adhesive layer 25a. Therefore, there is a case where the side surface of adhesive layer 25a is not surrounded by the barrier layer 26, and after the dielectric bonding layer 24 is formed, the dielectric bonding layer 24 covers the side surface of the adhesive layer 25a.

In some embodiments, refer to FIG. 5A. The integrated circuit 100 further includes a virtual connection pattern 27 and a virtual barrier layer 28. The virtual connection pattern 27 runs through the dielectric bonding layer 24, but the virtual connection pattern 27 does not need to be electrically connected to the metal trace 220 in the wiring layer 22.

Still refer to FIG. 5A. The virtual connection pattern 27 includes a virtual seed layer 27b and a virtual conductive block 27c that are stacked, and the virtual seed layer 27b is located on a side that is of the virtual conductive block 27c and that is close to the substrate 20. The virtual barrier layer 28 is disposed between the virtual conductive block 27c and the dielectric bonding layer 24, and the virtual barrier layer 28 surrounds a side surface of the virtual conductive block 27c.

The virtual seed layer 27b and the seed layer 25b of the connection pattern 25 are made of a same material and disposed at a same layer, the virtual conductive block 27c and the conductive block 25c of the connection pattern 25 are made of a same material and disposed at a same layer, and the virtual barrier layer 28 and the barrier layer 26 are made of a same material and disposed at a same layer.

For example, refer to FIG. 5A. The virtual connection pattern 27 further includes a virtual adhesive layer 27a, and the virtual adhesive layer 27a is disposed on a side that is of the virtual seed layer 27b and that is close to the substrate 20. The virtual adhesive layer 27a and the adhesive layer 25a of the connection pattern 25 are made of a same material and disposed at a same layer.

It should be noted that "a same layer" refers to a layer structure formed by first forming a film layer for forming a particular pattern through a same film forming process, and then by using a same mask through a single patterning process. Based on different particular patterns, one patterning process may include a plurality of exposure, development, or etching processes. Moreover, the particular patterns in the formed layer structure may be continuous or discontinuous, and these particular patterns may also have different heights or different thicknesses.

That is, the virtual adhesive layer 27a and the adhesive layer 25a can be formed in a same preparation process step; the virtual seed layer 27b and the seed layer 25b can be formed in a same preparation process step; the virtual conductive block 27c and the conductive block 25c can be formed in a same preparation process step; and the virtual barrier layer 28 and the barrier layer 26 can be formed in a same preparation process step.

In the foregoing embodiment of this application, the virtual connection pattern 27 does not need to be electrically connected to the metal trace 220, that is, the virtual connection pattern 27 does not transmit an electrical signal. The virtual connection pattern 27 is disposed on the surface of the integrated circuit 100, and the virtual connection pattern 27 and the connection pattern 25 are evenly distributed on the surface of the integrated circuit 100. This can improve uniformity of structural strength of the surface of the integrated circuit 100. In the process of preparing the integrated circuit 100, the surface of the integrated circuit 100 is polished. Uniformity of polishing can be improved by improving the uniformity of the structural strength of the integrated circuit 100, thereby improving polishing quality and flatness of the surface of the integrated circuit 100.

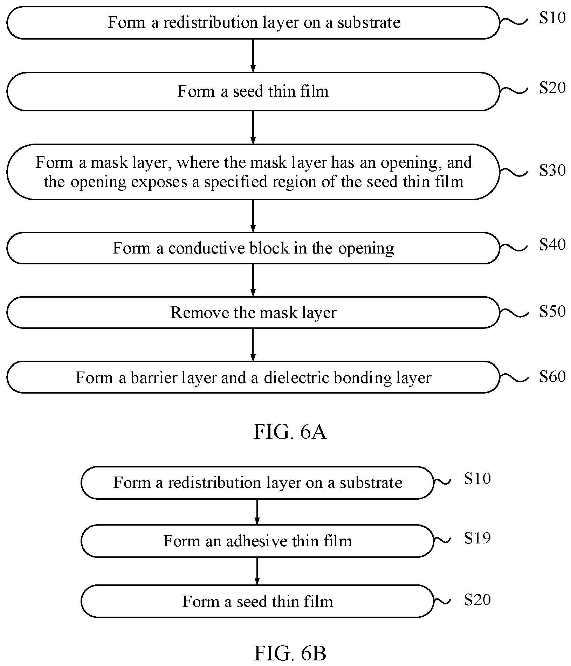

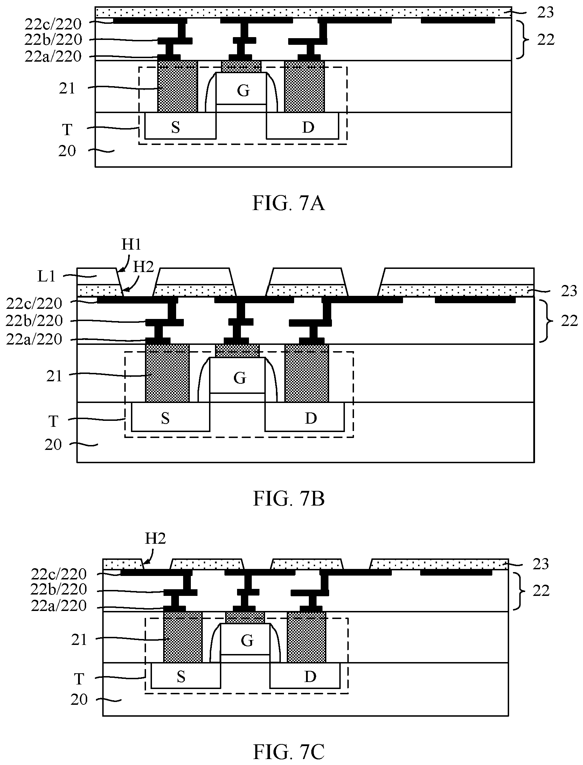

Some embodiments of this application further provide an integrated circuit preparation method. The preparation method is used to prepare the integrated circuit 100 in FIG. 5A. FIG. 6A to FIG. 6E are flowcharts of preparing an integrated circuit according to some embodiments. FIG. 7A to FIG. 7K are diagrams of steps of preparing an integrated circuit according to some embodiments.

Refer to FIG. 6A. The preparation method includes the following steps of S10 to S60.

S10: As shown in FIG. 7A, form a wiring layer 22 on a substrate 20, where the wiring layer 22 includes a metal trace 220.

In some examples, as shown in FIG. 7A, after the wiring layer 22 is formed on the substrate 20, an insulation layer 23 is further formed on a side that is of the wiring layer 22 and that is away from the substrate 20.

As shown in FIG. 7B, a mask layer L1 is formed on a side that is of the insulation layer 23 and that is away from the substrate 20. The mask layer L1 has an opening H1. The insulation layer 23 is etched through the opening H1, to form a via H2 running through the insulation layer 23, and the via H2 exposes the metal trace 220 in the wiring layer 22.

It should be noted that the mask layer L1 may be an organic photoresist layer or an inorganic hard mask layer.

As shown in FIG. 7B and FIG. 7C, after the insulation layer 23 is etched, the mask layer L1 is removed.

In some examples, refer to FIG. 6B. After the wiring layer 22 is formed on the substrate 20 in S10, the preparation method further includes the following S19.

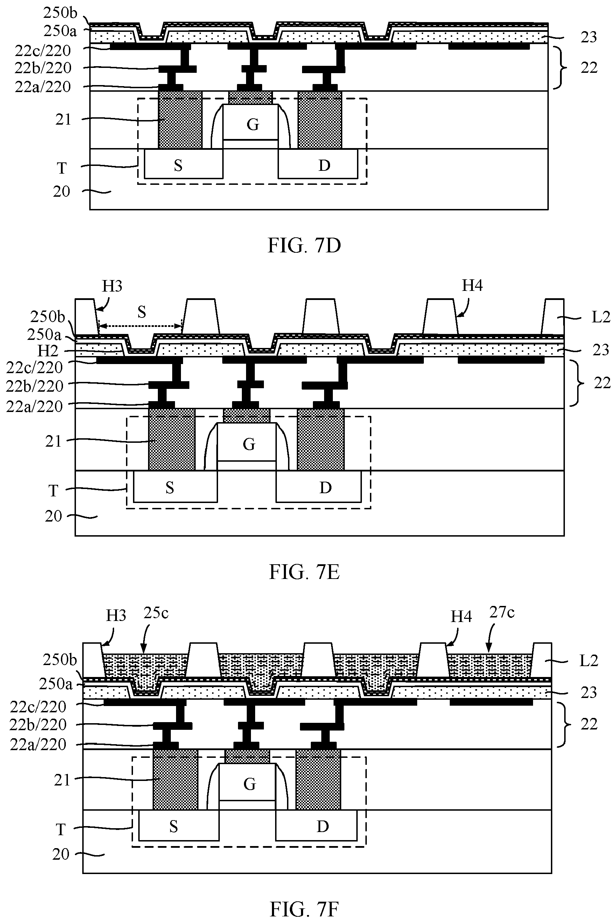

S19: As shown in FIG. 7C and FIG. 7D, form an adhesive thin film 250a, where the adhesive thin film 250a is located on the side that is of the wiring layer 22 and that is away from the substrate 20. The adhesive thin film 250a is electrically connected to the metal trace 220 in the wiring layer 22 through the via H2 in the insulation layer 23.

S20: As shown in FIG. 7D, form a seed thin film 250b, where the seed thin film 250b is located on the side that is of the wiring layer 22 and that is away from the substrate 20. In addition, the seed thin film 250b is further located on a side that is of the adhesive thin film 250a and that is away from the substrate 20, and the adhesive thin film 250a may adhere to the seed thin film 250b.

For example, a physical vapor deposition process may be used to form the seed thin film 250b.

S30: As shown in FIG. 7E, form a mask layer L2, where the mask layer L2 is located on a side that is of the seed thin film 250b and that is away from the substrate 20, the mask layer L2 has an opening H3, and the opening L3 exposes a specified region S of the seed thin film 250b.

It should be noted that, an orthographic projection of the specified region S of the seed thin film 250b on the substrate 20 needs to at least partially overlap an orthographic projection of the via H2 in the insulation layer 23 on the substrate 20. For example, the orthographic projection of the specified region S on the substrate 20 covers the orthographic projection of the via H2 on the substrate 20. In this way, after a conductive block is subsequently formed in the opening H3, the seed thin film 250b and the adhesive thin film 250a are etched by using the conductive block as a mask, to retain portions that are of the seed thin film 250b and the adhesive thin film 250a and that are located in the via H2. This ensures that the conductive block can be electrically connected to the metal trace 220 through the portions that are of the seed thin film 250b and the adhesive thin film 250a and that are located in the via H2.

In addition, refer to FIG. 7E. The mask layer L2 further has an opening H4, where the opening H4 exposes the seed thin film 250b, and a virtual conductive block may be subsequently formed in the opening H4.

S40: As shown in FIG. 7E and FIG. 7F, form a conductive block 25c in the opening H3.

For example, copper may be deposited in the specified region S of the seed thin film 250b by using an electroplating process, to form the conductive block 25c.

It can be understood that because the opening H4 also exposes the seed thin film 250b, a virtual conductive block 27c is also formed in the opening H4 during formation of the conductive block 25c in the opening H3.

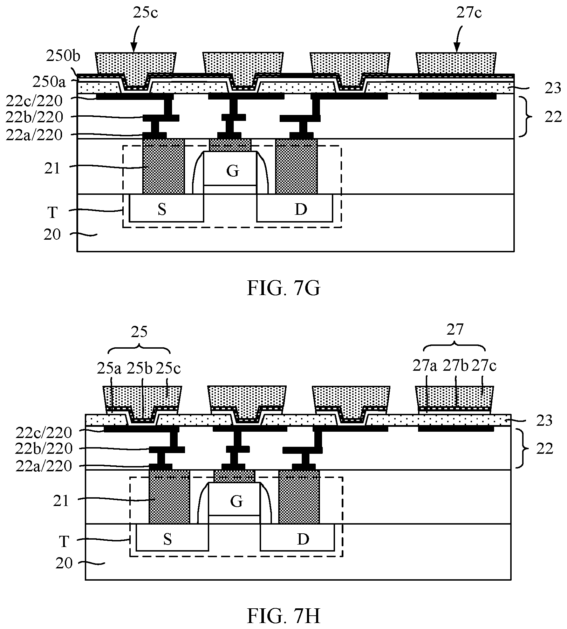

S50: As shown in FIG. 7F and FIG. 7G, remove the mask layer L2, to expose a side surface of the conductive block 25c.

It may be understood that, after the mask layer L2 is removed, a side surface of the virtual conductive block 27c is also exposed.

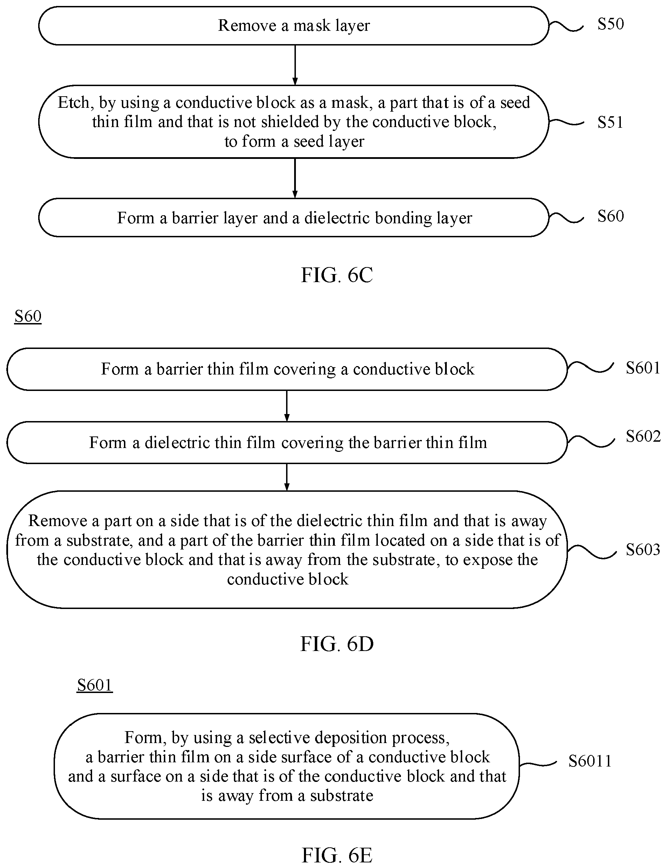

In some examples, refer to FIG. 6C. After the mask layer L2 is removed in S50, the preparation method further includes the following S51.

S51: As shown in FIG. 7G and FIG. 7H, etch, by using the conductive block 25c as a mask, a part that is of the seed thin film 250b and that is not shielded by the conductive block 25c, to form a seed layer 25b. This can avoid adding the mask layer for etching the seed thin film 250b, and simplify the preparation process.

It may be understood that, in the process of etching the part that is of the seed thin film 250b and that is not shielded by the conductive block 25c, a part that is of the adhesive thin film 250a and that is not shielded by the conductive block 25c is further etched, to form an adhesive layer 25a. This can avoid adding the mask layer for etching the adhesive thin film 250a, and simplify the preparation process.

In addition, the virtual conductive block 27c and the conductive block 25c together serve as a mask to etch the seed thin film 250b and the adhesive thin film 250a.

In addition, in processes of etching the seed thin film 250b and the adhesive thin film 250a, parts that are of the seed thin film 250b and the adhesive thin film 250a and that are shielded by the conductive block 25c, and the insulation layer 23 can be used as the metal trace 220, to avoid the metal trace 220 from being damaged by etching and affecting transmission efficiency of an electrical signal on the metal trace 220.

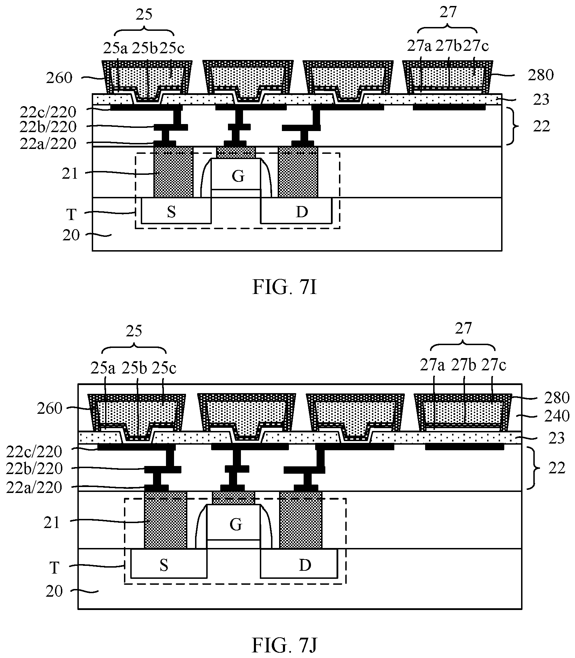

S60: As shown in FIG. 7I to FIG. 7K, form a barrier layer 26 and a dielectric bonding layer 24, where the barrier layer 26 surrounds a side surface of the conductive block 25c, and the dielectric bonding layer 24 is located on a side that is of the barrier layer 26 and that is away from the conductive block 25c.

In some examples, refer to FIG. 6D. S60 includes the following S601 to S603.

S601: As shown in FIG. 7I, form a barrier thin film 260 covering the conductive block 25c.

In some examples, refer to FIG. 6E. S601 includes the following S6011.

S6011: As shown in FIG. 7I, form, by using a selective deposition process, the barrier thin film 260 on the side surface of the conductive block 25c and a surface on the side that is of the conductive block 25c and that is away from the substrate 20. For example, the selective deposition process may include: an electroless deposition (Electroless Deposition, ELD for short) process, also referred to as an electroless plating (Electroless Plating) process, a selective chemical vapor deposition process, a selective atomic layer deposition process, and the like.

It should be noted that, according to the foregoing description, a material of the barrier layer 26 includes a metal material. Therefore, a material of the barrier thin film 260 includes a metal material, and a material of the insulation layer 23 includes a non-metallic material.

A feature of the "selective deposition process" is that under a same process condition, a deposition rate of a metal material on a surface of a metal material is greater than a deposition rate of the metal material on a surface of a non-metallic material. Therefore, in the process of depositing the material of the barrier thin film 260, a rate at which the material of the barrier thin film 260 is deposited on the surface of the conductive block 25c is greater than a rate at which the material of the barrier thin film 260 is deposited on the surface of the insulation layer 23. This implements the formation of the barrier thin film 260 on the side surface of the conductive block 25c and the surface on the side that is of the conductive block 25c and that is away from the substrate 20, and simplifies the preparation process.

It may be understood that, if a small quantity of materials of the barrier thin film 260 are deposited on the surface of the insulation layer 23, the materials may be removed by using an etching process. Alternatively, a deposition rate of the barrier thin film 260 on the surface of the insulation layer 23 can be controlled to be 0 by selecting a material of the barrier thin film 260, that is, the material of the barrier thin film 260 cannot be deposited on the surface of the insulation layer 23.

The barrier thin film 260 also covers a side surface of the seed layer 25b and a side surface of the adhesive layer 25a.

In addition, in a process of forming the barrier thin film 260, a virtual barrier thin film 280 covering the virtual conductive block 27c is further formed.

S602: As shown in FIG. 7J, form a dielectric thin film 240 covering the barrier thin film 260.

It may be understood that the dielectric thin film 240 also covers the virtual barrier thin film 280. In addition, a surface on the side that is of the dielectric thin film 240 and that is away from the substrate 20 is flat, to facilitate subsequent polishing.

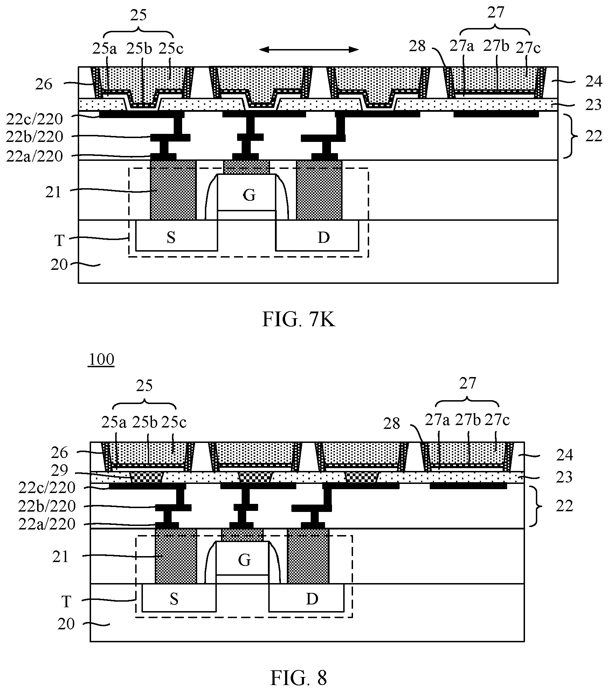

S603: As shown in FIG. 7K, remove a part that is of the dielectric thin film 240 and that is away from the substrate 20, and a part of the barrier thin film 260 located on the side that is of the conductive block 25c and that is away from the substrate 20, to expose the conductive block 25c.

For example, a chemical mechanical polishing (Chemical Mechanical Polishing, CMP for short) process may be used to polish the part that is of the dielectric thin film 240 and that is away from the substrate 20, and the part of the barrier thin film 260 located on the side that is of the conductive block 25c and that is away from the substrate 20, to expose the conductive block 25c.

It may be understood that, in a polishing process, a part of the virtual barrier thin film 280 located on a side that is of the virtual conductive block 27c and that is away from the substrate 20 is further removed, to expose the virtual conductive block 27c.

According to the preparation method provided in the foregoing embodiment of this application, the seed thin film 250b is first formed, and then the mask layer L2 having the opening H3 is formed on the seed thin film 250b, so that the seed thin film 250b is located at the bottom of the opening H3 and is not located on a side wall of the opening. In this way, in a process of forming the conductive block 25c in the opening H3, because the seed thin film 250b is disposed at the bottom of the opening H3, most regions of a surface of the seed thin film 250b are parallel to an upper surface of the conductive block 25c. This can improve consistency of distribution of specific crystal faces on the upper surface of the conductive block 25c, increase an area proportion of a

(111) crystal face on the upper surface of the conductive block 25c, and facilitate good bonding between conductive blocks 25c at a lower annealing temperature, thereby improving product reliability after bonding of the integrated circuit 100.

In addition, the barrier layer 26 surrounding the side surface of the conductive block 25c is formed, to avoid copper diffusion caused by direct contact between the conductive block 25c and the dielectric bonding layer 24, thereby further improving product reliability of the integrated circuit 100.

Some embodiments of this application further provide an integrated circuit. FIG. 8 is a diagram of a structure of another integrated circuit according to some embodiments.

A difference between the integrated circuit 100 in FIG. 8 and the integrated circuit 100 in FIG. 5A lies in that the integrated circuit 100 in FIG. 8 includes a conductive structure 29, where the conductive structure 29 runs through the insulation layer 23, one end of the conductive structure 29 is electrically connected to the metal trace 220 of the wiring layer 22, and the other end is electrically connected to the connection pattern 25. This implements an electrical connection between the metal trace 220 and the connection pattern 25.

In some embodiments, refer to FIG. 8. An end face that is of the conductive structure 29 and that is connected to the connection pattern 25 is coplanar with a surface on a side that is of the insulation layer 23 and that is away from the substrate 20. In this way, a surface at the bottom of the connection pattern 25 is flat.

In the foregoing embodiment of this application, in a process of preparing the integrated circuit 100, the surface at the bottom of the connection pattern 25 is flat, the seed layer 25b is formed on the surface, and then copper is deposited on the surface of the seed layer 25b to form the conductive block 25c. Because the seed layer 25b is disposed on the flat surface, the surface of the seed layer 25b is parallel to the upper surface of the conductive block 25c. This can further increase an area proportion of the (111) crystal face on the upper surface of the conductive block 25c, and facilitate good bonding between conductive blocks 25c at a lower annealing temperature.

The inventor of this application verifies through experiments that in the integrated circuit 100 in the foregoing embodiment, the area proportion of the (111) crystal face on the surface on the side that is of the conductive block 25c and that is away from the substrate 20 is greater than or equal to 80%. This can ensure good bonding between the conductive blocks 25c at a lower annealing temperature. For example, the area proportion of the (111) crystal face on the surface on the side that is of the conductive block 25c and that is away from the substrate 20 is 80%, 85%, 90%, 95%, or 99%.

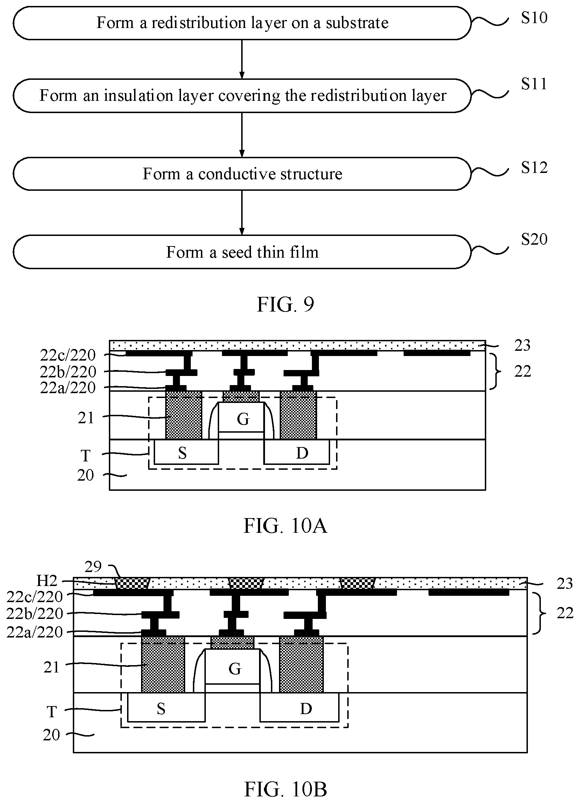

Some embodiments of this application further provide an integrated circuit preparation method. FIG. 9 is a flowchart of preparing another integrated circuit according to some embodiments. FIG. 10A to FIG. 10D are diagrams of steps of preparing an integrated circuit according to some embodiments.

The preparation method is for preparing the integrated circuit 100 in FIG. 8. A difference between the preparation method for preparing the integrated circuit 100 in FIG. 8 and the preparation method for preparing the integrated circuit 100 in FIG. 5A lies in that:

Refer to FIG. 9. After the forming a wiring layer 22 on a substrate 20 in S10, and before the forming a seed thin film 250b in S20, the preparation method includes the following S11 and S12.

S11: As shown in FIG. 10A, form an insulation layer 23 covering the wiring layer 22.

S12: As shown in FIG. 10B, form a conductive structure 29, where the conductive structure 29 runs through the insulation layer 23, and one end of the conductive structure 29 is electrically connected to a metal trace 220.

It may be understood that, the conductive structure 29 fills a via H2 of the insulation layer 23, so that a surface on a side that is of the insulation layer 23 and that is away from the substrate 20 is flat, and an adhesive thin film and a seed thin film are subsequently formed on the surface of the insulation layer 23.

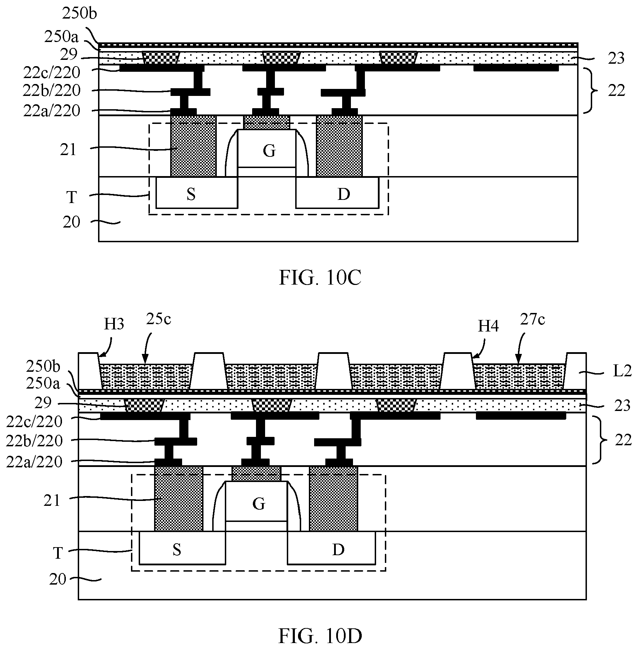

As shown in FIG. 10C, after the surface on the side that is of the insulation layer 23 and that is away from the substrate 20 is flat, to form the adhesive thin film 250a and the seed thin film 250b, surfaces of the adhesive thin film 250a and the seed thin film 250b are flat.

As shown in FIG. 10D, copper is deposited on a surface of the seed thin film 250b to form a conductive block 25c. Because the surface of the seed thin film 250b is flat, the surface of the seed thin film 250b is parallel to an upper surface of the conductive block 25c. This can increase an area proportion of a (111) crystal face on the upper surface of the conductive block 25c, and facilitate good bonding between conductive blocks 25c at a lower annealing temperature.

The foregoing preparation method is for preparing the integrated circuit 100 in FIG. 8, and similarities between the preparation method for preparing the integrated circuit 100 in FIG. 8 and the preparation method for preparing the integrated circuit 100 in FIG. 5A are not described again.

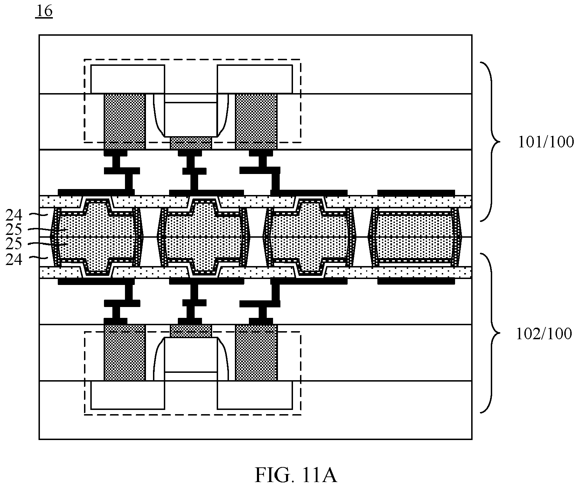

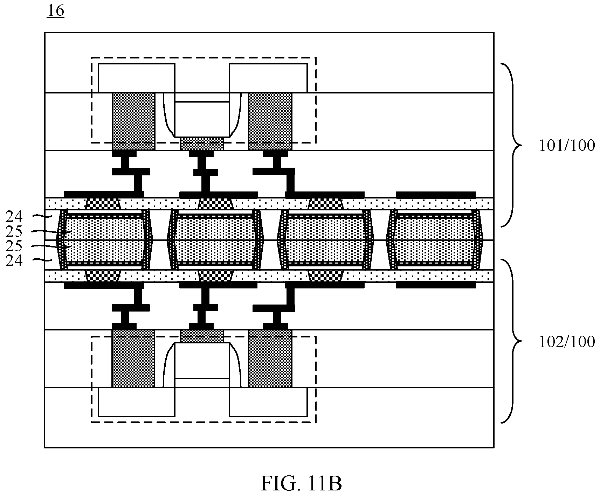

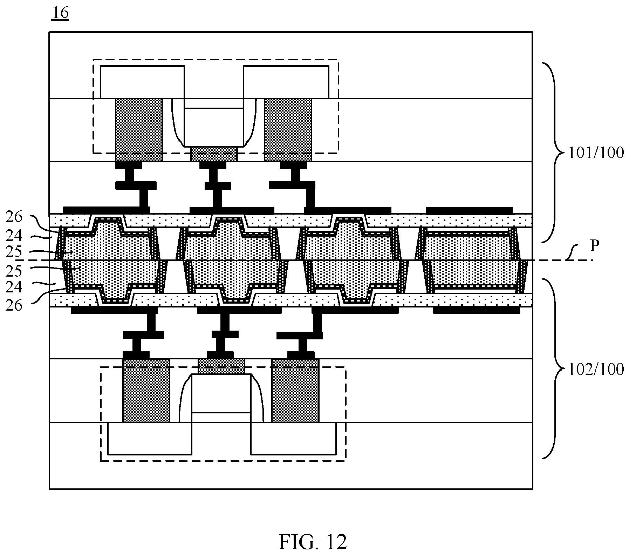

Some embodiments of this application provide two three-dimensional integrated circuits. FIG. 11A is a diagram of a structure of a three-dimensional integrated circuit according to some embodiments. FIG. 11B is a diagram of a structure of another three-dimensional integrated circuit according to some embodiments. FIG. 12 is a diagram of bonding between a first integrated circuit and a second integrated circuit according to some embodiments.

Refer to FIG. 11A and FIG. 11B. A three-dimensional integrated circuit 16 includes a first integrated circuit 101 and a second integrated circuit 102 that are disposed opposite to each other, and both the first integrated circuit 101 and the second integrated circuit 102 are the integrated circuit 100 described in any one of the foregoing embodiments.

A connection pattern 25 of the first integrated circuit 101 is bonded with a connection pattern 25 of the second integrated circuit 102, and a dielectric bonding layer 24 of the first integrated circuit 101 is bonded with a dielectric bonding layer 24 of the second integrated circuit 102, to implement bonding between the first integrated circuit 101 and the second integrated circuit 102.

In some embodiments, as shown in FIG. 11A and FIG. 11B, the connection pattern 25 of the first integrated circuit 101 is not in contact with the dielectric bonding layer 24 of the second integrated circuit 102. Similarly, the dielectric bonding layer 24 of the first integrated circuit 101 is not in contact with the connection pattern 25 of the second integrated circuit 102.

According to the foregoing description, copper diffusion may easily occur in direct contact between the conductive block 25c and the dielectric bonding layer 24. Therefore, during hybrid bonding, it is ensured that the connection patterns 25 of the two bonded integrated circuits 100 are not in contact with the dielectric bonding layers 24, to improve product reliability of the three-dimensional integrated circuit 16.

In some embodiments, as shown in FIG. 12, both a thickness of a barrier layer 26 of the first integrated circuit 101 and a thickness of a barrier layer of the second integrated circuit 102 are greater than or equal to an alignment limit deviation for performing hybrid bonding between the first integrated circuit 101 and the second integrated circuit 102.

It may be understood that, refer to FIG. 12. The "alignment limit deviation" indicates a maximum deviation of alignment between the first integrated circuit 101 and the second integrated circuit 102 along a plane direction of an attachment surface P between the first integrated circuit 101 and the second integrated circuit 102. FIG. 12 shows a maximum deviation location of alignment between the first integrated circuit 101 and the second integrated circuit 102. The connection pattern 25 of the first integrated circuit 101 is exactly not in contact with the dielectric bonding layer 24 of the second integrated circuit 102. Therefore, the thickness of the barrier layer 26 is set to be greater than or equal to alignment precision for the first integrated circuit 101 and the second integrated circuit 102, to ensure that the connection pattern 25 of the first integrated circuit 101 is not in contact with the dielectric bonding layer 24 of the second integrated circuit 102, or ensure that the dielectric bonding layer 24 of the first integrated circuit 101 is not in contact with the connection pattern 25 of the second integrated circuit 102, thereby further improving the product reliability of the three-dimensional integrated circuit 16.

For example, a thickness range of the barrier layer 26 is 10 nm to 1000 nm. For example, the thickness of the barrier layer 26 is 10 nm, 50 nm, 100 nm, 500 nm, or 1000 nm.

For example, alignment precision for performing hybrid bonding between the first integrated circuit 101 and the second integrated circuit 102 is 50 nm. In this case, a thickness range of the barrier layer 26 is 50 nm to 100 nm. For example, the thickness of the barrier layer 26 is 50 nm, 60 nm, 75 nm, 90 nm, or 100 nm.

Some embodiments of this application further provide a three-dimensional integrated circuit preparation method. The preparation method includes the following S1 and S2.

S1: Attach a first integrated circuit 101 to a second integrated circuit 102 in alignment.

For example, in a process of preparing the first integrated circuit 101 and the second integrated circuit 102, alignment marks are prepared on surfaces of the first integrated circuit 101 and the second integrated circuit 102. During hybrid bonding, alignment marks of the first integrated circuit 101 and the second integrated circuit 102 are separately captured to collect location information of the first integrated circuit 101 and the second integrated circuit 102 until the two integrated circuits are aligned.

Then, the first integrated circuit 101 is attached to the second integrated circuit 102.

S2: Perform annealing treatment on the first integrated circuit 101 and the second integrated circuit 102 that are attached, where a temperature of the annealing treatment is less than or equal to 300°C.

For example, a temperature range for the annealing treatment is 150°C to 300°C. For example, the temperature for the annealing treatment is 150°C, 200°C, 225°C, 250°C, or 300°C.

For example, in an inert gas, annealing treatment may be performed on the first integrated circuit 101 and the second integrated circuit 102 that are attached. Duration of the annealing treatment may be within one hour to eight hours. The inert gas can prevent a surface of the connection pattern 25 of the integrated circuit 100 from being oxidized, thereby avoiding impact on bonding quality.

In some embodiments, before the attaching a first integrated circuit 101 to a second integrated circuit 102 in alignment, the preparation method further includes the following S01:

S01: Perform activation treatment and hydrophilicity treatment on an attachment surface between the first integrated circuit 101 and the second integrated circuit 102.

It should be noted that, the "activation treatment" means a treatment on the attachment surface between the first integrated circuit 101 and the second integrated circuit 102 by using a plasma, for example, a nitrogen plasma, to remove impurities on the attachment surface and an oxide layer of copper on the surface of the connection pattern 25.

The "hydrophilicity treatment" means that a hydroxy group (chemical formula: -OH) is formed on a surface of the dielectric bonding layer 24, and the hydroxy group is a hydrophilic group. This can increase strength of bonding between the dielectric bonding layers 24 of the first integrated circuit 101 and the second integrated circuit 102. In addition, a larger quantity of hydroxy groups on the surface of the dielectric bonding layer 24 indicates higher bonding strength.

The electronic device 1 provided in some embodiments of this application includes the three-dimensional integrated circuit 16 provided in any one of the foregoing embodiments. The three-dimensional integrated circuit 16 includes the integrated circuit 100 provided in any one of the foregoing embodiments. For beneficial effect that can be achieved by the electronic device 1, refer to the beneficial effect of the integrated circuit 100. Details are not described herein again.

## Claims

1. An integrated circuit (100), comprising:
a substrate (20);
an electronic component (T), disposed on the substrate (20);
a wiring layer (22), disposed on the substrate (20) and electrically connected to the electronic component (T), wherein the wiring layer (22) comprises a metal trace (220);
a dielectric bonding layer (24), disposed on a side that is of the wiring layer (22) and that is away from the substrate (20);
a connection pattern (25), running through the dielectric bonding layer (24) and electrically connected to the metal trace (220), wherein the connection pattern (25) comprises a seed layer (25b) and a conductive block (25c) that are stacked, and the seed layer (25b) is located on a side that is of the conductive block (25c) and that is close to the substrate (20); and
a barrier layer (26), disposed between the conductive block (25c) and the dielectric bonding layer (24), and surrounding a side surface of the conductive block (25c);
wherein the connection pattern (25) further comprises an adhesive layer (25a) disposed on a side that is of the seed layer (25b) and that is close to the substrate (20);
wherein a material of the adhesive layer (25a) comprises at least one of Ti, TiN, Ta, and TaN; and
wherein a material of the barrier layer (26) comprises at least one of Co, CoP, CoWP, CoB, CoWB, Ni, NiP, NiWP, NiMoP, NiB, and NiMoB;
**characterized in that**
the dielectric bonding layer (24) covers a side surface of the adhesive layer (25a).

2. The integrated circuit (100) according to claim 1, wherein the barrier layer (26) is further disposed between the seed layer (25b) and the dielectric bonding layer (24), and surrounds a side surface of the seed layer (25b).

3. The integrated circuit (100) according to claim 1 or 2, further comprising:
an insulation layer (23), disposed between the wiring layer (22) and the connection pattern (25); and
a conductive structure (29), running through the insulation layer (23), wherein one end of the conductive structure (29) is electrically connected to the metal trace (220), and the other end is electrically connected to the connection pattern (25).

4. The integrated circuit (100) according to claim 3, wherein an end face that is of the conductive structure (29) and that is connected to the connection pattern (25) is coplanar with a surface on a side that is of the insulation layer (23) and that is away from the substrate (20).

5. The integrated circuit (100) according to any one of claims 1 to 4, wherein a material of the conductive block (25c) comprises copper; and
an area proportion of a (111) crystal face on a surface on a side that is of the conductive block (25c) and that is away from the substrate (20) is greater than or equal to 80%.

6. The integrated circuit (100) according to any one of claims 1 to 5, further comprising:
a virtual connection pattern (27) running through the dielectric bonding layer (24), wherein the virtual connection pattern (27) comprises a virtual seed layer (27b) and a virtual conductive block (27c) that are stacked, and the virtual seed layer (27b) is located on a side that is of the virtual conductive block (27c) and that is close to the substrate (20); and
a virtual barrier layer (28), disposed between the virtual conductive block (27c) and the dielectric bonding layer (24), and surrounding a side surface of the virtual conductive block (27c), wherein
the virtual seed layer (27b) and the seed layer (25b) of the connection pattern (25) are made of a same material and disposed at a same layer, the virtual conductive block (27c) and the conductive block (25c) of the connection pattern (25) are made of a same material and disposed at a same layer, and the virtual barrier layer (28) and the barrier layer (26) are made of a same material and disposed at a same layer.

7. An integrated circuit preparation method, comprising:
forming (S10) a wiring layer on a substrate, wherein the wiring layer comprises a metal trace;
forming (S20) a seed thin film, wherein the seed thin film is located on a side that is of the wiring layer and that is away from the substrate;
forming (S30) a mask layer, wherein the mask layer is located on a side that is of the seed thin film and that is away from the substrate, the mask layer has an opening, and the opening exposes a specified region of the seed thin film;
forming (S40) a conductive block in the opening;
removing (S50) the mask layer; and
forming (S60) a barrier layer and a dielectric bonding layer, wherein the barrier layer surrounds a side surface of the conductive block, and the dielectric bonding layer is located on a side that is of the barrier layer and that is away from the conductive block;
wherein the forming (S60) a barrier layer and a dielectric bonding layer comprises:
forming (S601) a barrier thin film covering the conductive block;
forming (S602) a dielectric thin film covering the barrier thin film; and
removing (S603) a part on a side that is of the dielectric thin film and that is away from the substrate, and a part of the barrier thin film located on a side that is of the conductive block and that is away from the substrate, to expose the conductive block;
wherein the forming (S601) a barrier thin film covering the conductive block comprises:
forming (S6011), by using a selective deposition process, the barrier thin film on the side surface of the conductive block and a surface on the side that is of the conductive block and that is away from the substrate;
wherein after the removing (S50) the mask layer and before the forming (S60) a barrier thin film covering the conductive block, the method further comprises:
etching (S51), by using the conductive block as a mask, a part that is of the seed thin film and that is not shielded by the conductive block, to form a seed layer, wherein
the barrier thin film further covers a side surface of the seed layer;
wherein after the forming (S10) a wiring layer on a substrate and before the forming (S20) a seed thin film, the method further comprises:
forming (S19) an adhesive thin film, wherein the adhesive thin film is located on the side that is of the wiring layer and that is away from the substrate, wherein
in a process of etching (S51) the part that is of the seed thin film and that is not shielded by the conductive block, a part that is of the adhesive thin film and that is not shielded by the conductive block is further etched, to form an adhesive layer;
wherein a material of the adhesive layer comprises at least one of Ti, TiN, Ta, and TaN; and
wherein a material of the barrier layer comprises at least one of Co, CoP, CoWP, CoB, CoWB, Ni, NiP, NiWP, NiMoP, NiB, and NiMoB;
**characterized in that**
in the selective deposition process a rate at which the material of the barrier thin film is deposited on the side surface of the seed layer and the side surface of the conductive block is controlled to be greater than a rate at which the material of the barrier thin film is deposited on the side surface of the adhesive layer so that, after the dielectric bonding layer is formed, the dielectric bonding layer covers a side surface of the adhesive layer.

8. The preparation method according to claim 7, wherein after the forming (S10) a wiring layer on a substrate and before the forming (S20) a seed thin film, the method further comprises:
forming (S11) an insulation layer covering the wiring layer; and
forming (S12) a conductive structure, wherein the conductive structure runs through the insulation layer, and one end of the conductive structure is electrically connected to the metal trace.

9. A three-dimensional integrated circuit (16), comprising:
a first integrated circuit (101) and a second integrated circuit (102) that are disposed opposite to each other, wherein both the first integrated circuit (101) and the second integrated circuit (102) are the integrated circuit (100) according to any one of claims 1 to 6, wherein
a connection pattern (25) of the first integrated circuit (101) is bonded with a connection pattern (25) of the second integrated circuit (102), and a dielectric bonding layer (24) of the first integrated circuit (101) is bonded with a dielectric bonding layer (24) of the second integrated circuit (102).

10. The three-dimensional integrated circuit (16) according to claim 9, wherein the connection pattern (25) of the first integrated circuit (101) is not in contact with the dielectric bonding layer (24) of the second integrated circuit (102).

11. The three-dimensional integrated circuit (16) according to claim 9 or 10, wherein both a thickness of a barrier layer (26) of the first integrated circuit (101) and a thickness of a barrier layer (26) of the second integrated circuit (102) are greater than or equal to an alignment limit deviation for performing hybrid bonding between the first integrated circuit (101) and the second integrated circuit (102).

12. A three-dimensional integrated circuit preparation method, wherein the preparation method is applied to preparing the three-dimensional integrated circuit (16) according to any one of claims 9 to 11; and
the preparation method comprises:
attaching a first integrated circuit (101) to a second integrated circuit (102) in alignment; and
performing annealing treatment on the first integrated circuit (101) and the second integrated circuit (102) that are attached, wherein a temperature of the annealing treatment is less than or equal to 300°C.

13. The preparation method according to claim 12, wherein before the attaching a first integrated circuit (101) to a second integrated circuit (102) in alignment, the method further comprises:
performing activation treatment and hydrophilicity treatment on an attachment surface between the first integrated circuit (101) and the second integrated circuit (102).

14. An electronic device (1), comprising:
a circuit board (15); and
the three-dimensional integrated circuit (16) according to any one of claims 9 to 11, wherein the three-dimensional integrated circuit (16) is electrically connected to the circuit board (15).

## Patentansprüche

1. Integrierte Schaltung (100), die Folgendes umfasst:
ein Substrat (20);
eine elektronische Komponente (T), die auf dem Substrat (20) angeordnet ist;
eine Verdrahtungsschicht (22), die auf dem Substrat (20) angeordnet und mit der elektronischen Komponente (T) elektrisch verbunden ist, wobei die Verdrahtungsschicht (22) eine Metallleiterbahn (220) umfasst;
eine dielektrische Bondschicht (24), die auf einer Seite angeordnet ist, die zu der Verdrahtungsschicht (22) gehört und die von dem Substrat (20) entfernt ist;
ein Verbindungsmuster (25), das durch die dielektrische Bondschicht (24) verläuft und mit der Metallleiterbahn (220) elektrisch verbunden ist, wobei das Verbindungsmuster (25) eine Keimschicht (25b) und einen leitenden Block (25c) umfasst, die gestapelt sind, und die Keimschicht (25b) sich auf einer Seite befindet, die zu dem leitenden Block (25c) gehört und die nahe bei dem Substrat (20) ist; und
eine Barriereschicht (26), die zwischen dem leitenden Block (25c) und der dielektrischen Bondschicht (24) angeordnet ist und eine Seitenoberfläche des leitenden Blocks (25c) umgibt;
wobei das Verbindungsmuster (25) ferner eine Haftschicht (25a) umfasst, die auf einer Seite angeordnet ist, die zu der Keimschicht (25b) gehört und die nahe bei dem Substrat (20) ist;
wobei ein Material der Haftschicht (25a) mindestens eines von Ti, TiN, Ta und TaN umfasst; und
wobei ein Material der Barriereschicht (26) mindestens eines von Co, CoP, CoWP, CoB, CoWB, Ni, NiP, NiWP, NiMoP, NiB und NiMoB umfasst,
**dadurch gekennzeichnet, dass**
die dielektrische Bondschicht (24) eine Seitenoberfläche der Haftschicht (25a) bedeckt.

2. Integrierte Schaltung (100) nach Anspruch 1, wobei die Barriereschicht (26) ferner zwischen der Keimschicht (25b) und der dielektrischen Bondschicht (24) angeordnet ist und eine Seitenoberfläche der Keimschicht (25b) umgibt.

3. Integrierte Schaltung (100) nach Anspruch 1 oder 2, die ferner Folgendes umfasst:
eine Isolierschicht (23), die zwischen der Verdrahtungsschicht (22) und dem Verbindungsmuster (25) angeordnet ist; und
eine leitende Struktur (29), die durch die Isolierschicht (23) verläuft, wobei ein Ende der leitenden Struktur (29) mit der Metallleiterbahn (220) elektrisch verbunden ist und das andere Ende mit dem Verbindungsmuster (25) elektrisch verbunden ist.

4. Integrierte Schaltung (100) nach Anspruch 3, wobei eine Endfläche, die zu der leitenden Struktur (29) gehört und die mit dem Verbindungsmuster (25) verbunden ist, mit einer Oberfläche auf einer Seite, die zu der Isolierschicht (23) gehört und die von dem Substrat (20) entfernt ist, in derselben Ebene liegt.

5. Integrierte Schaltung (100) nach einem der Ansprüche 1 bis 4, wobei ein Material des leitenden Blocks (25c) Kupfer umfasst; und
ein Flächenanteil einer (111) Kristallfläche auf einer Oberfläche auf einer Seite, die zu dem leitenden Block (25c) gehört und die von dem Substrat (20) entfernt ist, größer als oder gleich 80 % ist.

6. Integrierte Schaltung (100) nach einem der Ansprüche 1 bis 5, die ferner Folgendes umfasst:
ein virtuelles Verbindungsmuster (27), das durch die dielektrische Bondschicht (24) verläuft, wobei das virtuelle Verbindungsmuster (27) eine virtuelle Keimschicht (27b) und einen virtuellen leitenden Block (27c) umfasst, die gestapelt sind, und die virtuelle Keimschicht (27b) sich auf einer Seite befindet, die zu dem virtuellen leitenden Block (27c) gehört und die nahe bei dem Substrat (20) ist; und
eine virtuelle Barriereschicht (28), die zwischen dem virtuellen leitenden Block (27c) und der dielektrischen Bondschicht (24) angeordnet ist und eine Seitenoberfläche des virtuellen leitenden Blocks (27c) umgibt, wobei
die virtuelle Keimschicht (27b) und die Keimschicht (25b) des Verbindungsmusters (25) aus einem selben Material gefertigt und an einer selben Schicht angeordnet sind, der virtuelle leitende Block (27c) und der leitende Block (25c) des Verbindungsmusters (25) aus einem selben Material gefertigt und an einer selben Schicht angeordnet sind und die virtuelle Barriereschicht (28) und die Barriereschicht (26) aus einem selben Material gefertigt und an einer selben Schicht angeordnet sind.

7. Verfahren zur Herstellung einer integrierten Schaltung, das Folgendes umfasst:
Bilden (S10) einer Verdrahtungsschicht auf einem Substrat, wobei die Verdrahtungsschicht eine Metallleiterbahn umfasst;
Bilden (S20) einer dünnen Keimschicht, wobei die dünne Keimschicht sich auf einer Seite befindet, die zu der Verdrahtungsschicht gehört und die von dem Substrat entfernt ist;
Bilden (S30) einer Maskenschicht, wobei die Maskenschicht sich auf einer Seite befindet, die zu der dünnen Keimschicht gehört und die von dem Substrat entfernt ist, die Maskenschicht eine Öffnung aufweist und die Öffnung einen festgelegten Bereich der dünnen Keimschicht freilegt;
Bilden (S40) eines leitenden Blocks in der Öffnung;
Entfernen (S50) der Maskenschicht; und
Bilden (S60) einer Barriereschicht und einer dielektrischen Bondschicht, wobei die Barriereschicht eine Seitenoberfläche des leitenden Blocks umgibt und die dielektrische Bondschicht sich auf einer Seite befindet, die zu der Barriereschicht gehört und die von dem leitenden Block entfernt ist;
wobei das Bilden (S60) einer Barriereschicht und einer dielektrischen Bondschicht Folgendes umfasst:
Bilden (S601) einer dünnen Barriereschicht, die den leitenden Block bedeckt;
Bilden (S602) einer dünnen dielektrischen Schicht, die die dünne Barriereschicht bedeckt; und
Entfernen (S603) eines Teils auf einer Seite, die zu der dünnen dielektrischen Schicht gehört und die von dem Substrat entfernt ist, und eines Teils der dünnen Barriereschicht auf einer Seite, die zu dem leitenden Block gehört und die von dem Substrat entfernt ist, um den leitenden Block freizulegen;
wobei das Bilden (S601) einer dünnen Barriereschicht, die den leitenden Block bedeckt, Folgendes umfasst:
Bilden (S6011), unter Nutzung eines Prozesses einer selektiven Abscheidung, der dünnen Barriereschicht auf der Seitenoberfläche des leitenden Blocks und einer Oberfläche auf der Seite, die zu dem leitenden Block gehört und die von dem Substrat entfernt ist;
wobei das Verfahren nach dem Entfernen (S50) der Maskenschicht und vor dem Bilden (S60) einer dünnen Barriereschicht, die den leitenden Block bedeckt, ferner Folgendes umfasst:
Ätzen (S51), unter Nutzung des leitenden Blocks als Maske, eines Teils, der zu der dünnen Keimschicht gehört und der nicht durch den leitenden Block abgeschirmt wird, um eine Keimschicht zu bilden, wobei
die dünne Barriereschicht ferner eine Seitenoberfläche der Keimschicht bedeckt;
wobei das Verfahren nach dem Bilden (S10) einer Verdrahtungsschicht auf einem Substrat und vor dem Bilden (S20) einer dünnen Keimschicht ferner Folgendes umfasst:
Bilden (S19) einer dünnen Haftschicht, wobei die dünne Haftschicht sich auf der Seite befindet, die zu der Verdrahtungsschicht gehört und die von dem Substrat entfernt ist, wobei
bei einem Prozess des Ätzens (S51) des Teils, der zu der dünnen Keimschicht gehört und der nicht durch den leitenden Block abgeschirmt wird, ein Teil, der zu der dünnen Haftschicht gehört und der nicht durch den leitenden Block abgeschirmt wird, weiter geätzt wird, um eine Haftschicht zu bilden;
wobei ein Material der Haftschicht mindestens eines von Ti, TiN, Ta und TaN umfasst; und
wobei ein Material der Barriereschicht mindestens eines von Co, CoP, CoWP, CoB, CoWB, Ni, NiP, NiWP, NiMoP, NiB und NiMoB umfasst;
**dadurch gekennzeichnet, dass**
bei dem Prozess einer selektiven Abscheidung eine Rate, mit der das Material der dünnen Barriereschicht auf der Seitenoberfläche der Keimschicht und der Seitenoberfläche des leitenden Blocks abgeschieden wird, so geregelt wird, dass sie größer als eine Rate ist, mit der das Material der dünnen Barriereschicht auf der Seitenoberfläche der Haftschicht abgeschieden wird, sodass, nachdem die dielektrische Bondschicht gebildet worden ist, die dielektrische Bondschicht eine Seitenoberfläche der Haftschicht bedeckt.

8. Herstellungsverfahren nach Anspruch 7, wobei das Verfahren nach dem Bilden (S10) einer Verdrahtungsschicht auf einem Substrat und vor dem Bilden (S20) einer dünnen Keimschicht ferner Folgendes umfasst:
Bilden (S11) einer Isolierschicht, die die Verdrahtungsschicht bedeckt; und
Bilden (S12) einer leitenden Struktur, wobei die leitende Struktur durch die Isolierschicht verläuft und ein Ende der leitenden Struktur mit der Metallleiterbahn elektrisch verbunden ist.

9. Dreidimensionale integrierte Schaltung (16), die Folgendes umfasst:
eine erste integrierte Schaltung (101) und eine zweite integrierte Schaltung (102), die einander gegenüberliegend angeordnet sind, wobei es sich bei sowohl der ersten integrierten Schaltung (101) als auch der zweiten integrierten Schaltung (102) um die integrierte Schaltung (100) nach einem der Ansprüche 1 bis 6 handelt, wobei
ein Verbindungsmuster (25) der ersten integrierten Schaltung (101) mit einem Verbindungsmuster (25) der zweiten integrierten Schaltung (102) gebondet ist und eine dielektrische Bondschicht (24) der ersten integrierten Schaltung (101) mit einer dielektrischen Bondschicht (24) der zweiten integrierten Schaltung (102) gebondet ist.

10. Dreidimensionale integrierte Schaltung (16) nach Anspruch 9, wobei das Verbindungsmuster (25) der ersten integrierten Schaltung (101) nicht in Kontakt mit der dielektrischen Bondschicht (24) der zweiten integrierten Schaltung (102) steht.

11. Dreidimensionale integrierte Schaltung (16) nach Anspruch 9 oder 10, wobei sowohl eine Dicke einer Barriereschicht (26) der ersten integrierten Schaltung (101) als auch eine Dicke einer Barriereschicht (26) der zweiten integrierten Schaltung (102) größer als oder gleich einem Ausrichtungsabweichungsgrenzwert zum Durchführen eines hybriden Bondens zwischen der ersten integrierten Schaltung (101) und der zweiten integrierten Schaltung (102) sind.

12. Verfahren zur Herstellung einer dreidimensionalen integrierten Schaltung, wobei das Herstellungsverfahren auf das Herstellen der dreidimensionalen integrierten Schaltung (16) nach einem der Ansprüche 9 bis 11 angewendet wird; und
das Herstellungsverfahren Folgendes umfasst:
Befestigen einer ersten integrierten Schaltung (101) an einer zweiten integrierten Schaltung (102) in Ausrichtung; und
Durchführen einer Glühbehandlung an der ersten integrierten Schaltung (101) und der zweiten integrierten Schaltung (102), die befestigt sind, wobei eine Temperatur der Glühbehandlung kleiner als oder gleich 300 °C ist.

13. Herstellungsverfahren nach Anspruch 12, wobei das Verfahren vor dem Befestigen einer ersten integrierten Schaltung (101) an einer zweiten integrierten Schaltung (102) in Ausrichtung ferner Folgendes umfasst:
Durchführen einer Aktivierungsbehandlung und einer Hydrophilisierungsbehandlung an einer Befestigungsoberfläche zwischen der ersten integrierten Schaltung (101) und der zweiten integrierten Schaltung (102).

14. Elektronische Vorrichtung (1), die Folgendes umfasst:
eine Leiterplatte (15); und
die dreidimensionale integrierte Schaltung (16) nach einem der Ansprüche 9 bis 11, wobei die dreidimensionale integrierte Schaltung (16) mit der Leiterplatte (15) elektrisch verbunden ist.

## Revendications

1. Circuit intégré (100), comprenant :
un substrat (20) ;
un composant électronique (T), disposé sur le substrat (20) ;
une couche de câblage (22), disposée sur le substrat (20) et électriquement connectée au composant électronique (T), la couche de câblage (22) comprenant une piste métallique (220) ;
une couche de liaison diélectrique (24), disposée d'un côté de la couche de câblage (22) qui est éloigné du substrat (20) ;
un motif de connexion (25), s'étendant à travers la couche de liaison diélectrique (24) et électriquement connecté à la piste métallique (220), le motif de connexion (25) comprenant une couche germe (25b) et un bloc conducteur (25c) empilés, et la couche germe (25b) étant située d'un côté du bloc conducteur (25c) qui est proche du substrat (20) ; et
une couche barrière (26), disposée entre le bloc conducteur (25c) et la couche de liaison diélectrique (24), et entourant une surface latérale du bloc conducteur (25c) ;
le motif de connexion (25) comprenant en outre une couche adhésive (25a) disposée d'un côté de la couche germe (25b) qui est proche du substrat (20) ;
un matériau de la couche adhésive (25a) comprenant au moins un élément parmi Ti, TiN, Ta, et TaN ; et
un matériau de la couche barrière (26) comprenant au moins un élément parmi Co, CoP, CoWP, CoB, CoWB, Ni, NiP, NiWP, NiMoP, NiB, et NiMoB ;
**caractérisé en ce que**
la couche de liaison diélectrique (24) recouvre une surface latérale de la couche adhésive (25a).

2. Circuit intégré (100) selon la revendication 1, dans lequel la couche barrière (26) est en outre disposée entre la couche germe (25b) et la couche de liaison diélectrique (24), et entoure une surface latérale de la couche germe (25b).

3. Circuit intégré (100) selon la revendication 1 ou 2, comprenant en outre :
une couche d'isolation (23), disposée entre la couche de câblage (22) et le motif de connexion (25) ; et
une structure conductrice (29), s'étendant à travers la couche d'isolation (23), une extrémité de la structure conductrice (29) étant électriquement connectée à la piste métallique (220), et l'autre extrémité étant électriquement connectée au motif de connexion (25).

4. Circuit intégré (100) selon la revendication 3, dans lequel une face d'extrémité de la structure conductrice (29) qui est connectée au motif de connexion (25) est coplanaire avec une surface d'un côté de la couche d'isolation (23) qui est éloigné du substrat (20).

5. Circuit intégré (100) selon l'une quelconque des revendications 1 à 4, dans lequel un matériau du bloc conducteur (25c) comprend du cuivre ; et
une proportion surfacique d'une face de cristal (111) sur une surface d'un côté du bloc conducteur (25c) qui est éloigné du substrat (20) est supérieure ou égale à 80 %.

6. Circuit intégré (100) selon l'une quelconque des revendications 1 à 5, comprenant en outre :
un motif de connexion virtuel (27) s'étendant à travers la couche de liaison diélectrique (24), le motif de connexion virtuel (27) comprenant une couche germe virtuelle (27b) et un bloc conducteur virtuel (27c) empilés, et la couche germe virtuelle (27b) étant située d'un côté du bloc conducteur virtuel (27c) qui est proche du substrat (20) ; et
une couche barrière virtuelle (28), disposée entre le bloc conducteur virtuel (27c) et la couche de liaison diélectrique (24), et entourant une surface latérale du bloc conducteur virtuel (27c),
la couche germe virtuelle (27b) et la couche germe (25b) du motif de connexion (25) étant constituées d'un même matériau et disposées au niveau d'une même couche, le bloc conducteur virtuel (27c) et le bloc conducteur (25c) du motif de connexion (25) étant constitués d'un même matériau et disposés au niveau d'une même couche, et la couche barrière virtuelle (28) et la couche barrière (26) étant constituées d'un même matériau et disposées au niveau d'une même couche.

7. Procédé de préparation de circuit intégré, comprenant :
la formation (S10) d'une couche de câblage sur un substrat, la couche de câblage comprenant une piste métallique ;
la formation (S20) d'un film mince germe, le film mince germe étant situé d'un côté de la couche de câblage qui est éloigné du substrat ;
la formation (S30) d'une couche de masque, la couche de masque étant située d'un côté du film mince germe qui est éloigné du substrat, la couche de masque étant pourvue d'une ouverture, et l'ouverture mettant à nu une région spécifiée du film mince germe ;
la formation (S40) d'un bloc conducteur dans l'ouverture ;
l'élimination (S50) de la couche de masque ; et
la formation (S60) d'une couche barrière et d'une couche de liaison diélectrique, la couche barrière entourant une surface latérale du bloc conducteur, et la couche de liaison diélectrique étant située d'un côté de la couche barrière qui est éloigné du bloc conducteur ;
la formation (S60) d'une couche barrière et d'une couche de liaison diélectrique comprenant :
la formation (S601) d'un film mince barrière recouvrant le bloc conducteur ;
la formation (S602) d'un film mince diélectrique recouvrant le film mince barrière ; et
l'élimination (S603) d'une partie d'un côté du film mince diélectrique qui est éloigné du substrat, et d'une partie du film mince barrière située d'un côté du bloc conducteur qui est éloigné du substrat, afin de mettre à nu le bloc conducteur ;
la formation (S601) d'un film mince barrière recouvrant le bloc conducteur comprenant :
la formation (S6011), au moyen d'un processus de dépôt sélectif, du film mince barrière sur la surface latérale du bloc conducteur et une surface du côté du bloc conducteur qui est éloigné du substrat ;
le procédé comprenant en outre, après l'élimination (S50) de la couche de masque et avant la formation (S60) d'un film mince barrière recouvrant le bloc conducteur :
la gravure (S51), au moyen du bloc conducteur servant de masque, d'une partie du film mince germe qui n'est pas protégée par le bloc conducteur, afin de former une couche germe,
le film mince barrière recouvrant en outre une surface latérale de la couche germe ;
le procédé comprenant en outre, après la formation (S10) d'une couche de câblage sur un substrat et avant la formation (S20) d'un film mince germe :
la formation (S19) d'un film mince adhésif, le film mince adhésif étant situé du côté de la couche de câblage qui est éloigné du substrat,
dans un processus de gravure (S51) de la partie du film mince germe qui n'est pas protégée par le bloc conducteur, une partie du film mince adhésif qui n'est pas protégée par le bloc conducteur faisant l'objet d'une gravure supplémentaire, afin de former une couche adhésive ;
un matériau de la couche adhésive comprenant au moins un élément parmi Ti, TiN, Ta, et TaN ; et
un matériau de la couche barrière comprenant au moins un élément parmi Co, CoP, CoWP, CoB, CoWB, Ni, NiP, NiWP, NiMoP, NiB, et NiMoB ;
**caractérisé en ce que**
dans le processus de dépôt sélectif, une vitesse de dépôt du matériau du film mince barrière sur la surface latérale de la couche germe et la surface latérale du bloc conducteur est réglée de manière à être supérieure à une vitesse de dépôt du matériau du film mince barrière sur la surface latérale de la couche adhésive de sorte que, après la formation de la couche de liaison diélectrique, la couche de liaison diélectrique recouvre une surface latérale de la couche adhésive.

8. Procédé de préparation selon la revendication 7, le procédé comprenant en outre, après la formation (S10) d'une couche de câblage sur un substrat et avant la formation (S20) d'un film mince germe :
la formation (S11) d'une couche d'isolation recouvrant la couche de câblage ; et
la formation (S12) d'une structure conductrice, la structure conductrice s'étendant à travers la couche d'isolation, et une extrémité de la structure conductrice étant électriquement connectée à la piste métallique.

9. Circuit intégré tridimensionnel (16), comprenant :
un premier circuit intégré (101) et un deuxième circuit intégré (102) disposés en regard l'un de l'autre, le premier circuit intégré (101) et le deuxième circuit intégré (102) étant tous deux le circuit intégré (100) selon l'une quelconque des revendications 1 à 6,
un motif de connexion (25) du premier circuit intégré (101) étant lié à un motif de connexion (25) du deuxième circuit intégré (102), et une couche de liaison diélectrique (24) du premier circuit intégré (101) étant liée à une couche de liaison diélectrique (24) du deuxième circuit intégré (102).

10. Circuit intégré tridimensionnel (16) selon la revendication 9, dans lequel le motif de connexion (25) du premier circuit intégré (101) n'est pas en contact avec la couche de liaison diélectrique (24) du deuxième circuit intégré (102).

11. Circuit intégré tridimensionnel (16) selon la revendication 9 ou 10, dans lequel une épaisseur d'une couche barrière (26) du premier circuit intégré (101) et une épaisseur d'une couche barrière (26) du deuxième circuit intégré (102) sont toutes deux supérieures ou égales à un écart limite d'alignement pour la réalisation d'une liaison hybride entre le premier circuit intégré (101) et le deuxième circuit intégré (102).

12. Procédé de préparation de circuit intégré tridimensionnel, le procédé de préparation étant appliqué à la préparation du circuit intégré tridimensionnel (16) selon l'une quelconque des revendications 9 à 11 ; et
le procédé de préparation comprenant :
la fixation en alignement d'un premier circuit intégré (101) à un deuxième circuit intégré (102) ; et
la réalisation d'un traitement de recuit sur le premier circuit intégré (101) et le deuxième circuit intégré (102) ainsi fixés, une température du traitement de recuit étant inférieure ou égale à 300 °C.

13. Procédé de préparation selon la revendication 12, le procédé comprenant en outre, avant la fixation en alignement d'un premier circuit intégré (101) à un deuxième circuit intégré (102) :
la réalisation d'un traitement d'activation et d'un traitement d'hydrophilie sur une surface de fixation entre le premier circuit intégré (101) et le deuxième circuit intégré (102).

14. Dispositif électronique (1), comprenant :
une carte de circuit imprimé (15) ; et
le circuit intégré tridimensionnel (16) selon l'une quelconque des revendications 9 à 11, le circuit intégré tridimensionnel (16) étant électriquement connecté à la carte de circuit imprimé (15).
